(19) **Europäisches Patentamt**
**European Patent Office**
**Office européen des brevets**

(11) **EP 4 282 572 A1**

(12) **EUROPEAN PATENT APPLICATION**
published in accordance with Art. 153(4) EPC

(43) Date of publication:
**29.11.2023 Bulletin 2023/48**

(21) Application number: **22742682.2**

(22) Date of filing: **21.01.2022**

(51) International Patent Classification (IPC):
**B23K 20/00** (2006.01)    **H01L 21/02** (2006.01)

(52) Cooperative Patent Classification (CPC):
**B23K 20/00; H01L 21/02**

(86) International application number:
**PCT/JP2022/002175**

(87) International publication number:
**WO 2022/158563 (28.07.2022 Gazette 2022/30)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **21.01.2021   JP 2021008275**
**01.10.2021   JP 2021162509**
**20.01.2022   PCT/JP2022/001970**

(71) Applicants:
• **Bondtech Co., Ltd.**
**Minami-ku**
**Kyoto-shi**
**Kyoto 601-8366 (JP)**

• **Suga, Tadatomo**
**Tokyo 164-0003 (JP)**

(72) Inventors:
• **SUGA, Tadatomo**
**Kyoto-shi, Kyoto 601-8366 (JP)**
• **YAMAUCHI, Akira**
**Tokyo 164-0003 (JP)**

(74) Representative: **Rüger Abel Patentanwälte
PartGmbB
Webergasse 3
73728 Esslingen a. N. (DE)**

(54) **JOINING METHOD, JOINING DEVICE, AND JOINING SYSTEM**

(57)    A bonding method for bonding two substrates (W1, W2) includes: a heat treatment process of heating a bonding surface to be bonded to each other of each of the two substrates (W1, W2) to a temperature higher than 60°C in a reduced-pressure atmosphere; an activation treatment process of activating the bonding surface of each of the two substrates (W1, W2) in a state of maintaining the reduced-pressure atmosphere after the heat treatment process; and a bonding process of bonding the two substrates (W1, W2) in a state of maintaining the reduced-pressure atmosphere after the activation treatment process. In the heat treatment process, the state of heating the bonding surface of each of the two substrates (W1, W2) to a temperature higher than 60°C may be maintained for 30 seconds or more in a state of maintaining the reduced-pressure atmosphere. The gas pressure in the heat treatment process may be $10^{-2}$ Pa or less.

EP 4 282 572 A1

# FIG.2

**Description**

Technical Field

The present invention relates to a bonding method, a bonder, and a bonding system.

Background Art

A bonding method in which a bonding surface is activated by causing particles having kinetic energy set in advance to collide with the bonding surface of each of two substrates to be bonded to each other, and then the two substrates are bonded by bringing the activated bonding surfaces of the two substrates into contact with each other has been proposed (e.g., see Patent Literature 1).

Citation List

Patent Literature

Patent Literature 1: JP 2014-113633 A

Summary of Invention

Technical Problem

In the bonding method described in Patent Literature 1, in a case where impurities adhere to the bonding surface of each of the two substrates, the impurities are removed by colliding particles before the bonding surface is activated. However, since the adhesion strength of the impurities varies, it is difficult to set the time for irradiating particles for removing the impurities to an appropriate time, and if the bonding surface is irradiated with the particles more than necessary, the bonding surface becomes rough, resulting in a risk of reduction of the bonding strength when the two substrates are bonded.

The present invention has been made in view of the above circumstances, and an object is to provide a bonding method, a bonder, and a bonding system capable of firmly bonding two bonded objects.

Solution to Problem

In order to achieve the above object, a bonding method according to the present invention is a bonding method for bonding two bonded objects, the bonding method including:

> a heat treatment process of heating at least one of bonding surfaces to be bonded to each other of the two bonded objects to a temperature higher than 60°C in a reduced-pressure atmosphere;
> an activation treatment process of activating the bonding surface of each of the two bonded objects in a state of maintaining a reduced-pressure atmosphere after the heat treatment process; and
> a bonding process of bonding the two bonded objects in a state of maintaining a reduced-pressure atmosphere after the activation treatment process.

A bonder according to the present invention as viewed from another viewpoint is a bonder that bonds two bonded objects, the bonder including:

> a chamber;
> a stage disposed in the chamber and supporting any one of the two bonded objects;
> a head disposed to oppose the stage in the chamber and supporting another of the two bonded objects;
> a first bonded object heating unit that heats at least one bonding surface of each of the two bonded objects to be bonded to each other to a temperature higher than 60°C in a state where the chamber or a standby chamber coupled to the chamber is in a reduced-pressure atmosphere;
> an activation treatment unit that performs an activation treatment of activating the bonding surface of each of the two bonded objects;
> a drive unit that moves at least one of the stage and the head to a first direction in which the stage and the head get close to each other or a second direction in which the stage and the head get away from each other; and
> a control unit that controls operation of each of the first bonded object heating unit, the activation treatment unit, and the drive unit,

wherein the control unit bonds the two bonded objects by controlling the first bonded object heating unit to heat at least one of the bonding surfaces of each of the two bonded objects to a temperature higher than 60°C in a state where the two bonded objects are separated from each other in a state of maintaining a reduced-pressure atmosphere, then controlling the activation treatment unit to perform the activation treatment on the bonding surface in a state of maintaining a reduced-pressure atmosphere, and then controlling the drive unit to move at least one of the stage and the head to the first direction in a state of maintaining a reduced-pressure atmosphere.

A bonding system according to the present invention as viewed from another viewpoint is a bonding system for bonding two bonded objects, the bonding system including:

a hydrophilization treatment device that hydrophilizes at least one of bonded surfaces of the two bonded objects using at least water;
a bonder including: a chamber; a first bonded object heating unit that heats at least one bonding surface of each of the two bonded objects to be bonded to each other to a temperature higher than 60°C in a state where the chamber or a standby chamber coupled to the chamber is in a reduced-pressure atmosphere; a stage disposed in the chamber and supporting any one of the two bonded objects; a head disposed to oppose the stage in the chamber and supporting another of the two bonded objects; and a drive unit that moves at least one of the stage and the head to a first direction in which the stage and the head get close to each other or a second direction in which the stage and the head get away from each other; and
a control unit that controls operation of each of the first bonded object heating unit and the drive unit,
wherein the control unit bonds the two bonded objects by controlling the first bonded object heating unit to heat at least one of the bonding surfaces of each of the two bonded objects to a temperature higher than 60°C in a state where the two bonded objects are separated from each other in a reduced-pressure atmosphere, and then controlling the drive unit to move at least one of the stage and the head to the first direction in a state of maintaining a reduced-pressure atmosphere.

Advantageous Effects of Invention

According to the present invention, a heat treatment process of heating a bonding surface of each of two bonded objects to a temperature higher than 60°C in a reduced-pressure atmosphere is performed in a state where the two bonded objects are separated from each other, and then the two bonded objects are bonded in a reduced-pressure atmosphere. Due to this, by heating the bonding surface of each of the two bonded objects to a temperature higher than 60°C in a reduced-pressure atmosphere, it is possible to vaporize and remove water or impurities existing on the bonding surface of the bonded object, or to suppress adhesion of water or impurities floating in the vicinity of the bonding surface of the bonded object, and therefore the bonding surface of the bonded object becomes easily activated or hydrophilized. Therefore, it is possible to increase the bonding strength of two bonded objects when the two bonded objects are bonded.

Brief Description of Drawings

FIG. 1 is a schematic configuration diagram of a bonding system according to a first embodiment of the present invention.
FIG. 2 is a schematic front view of a bonder according to the first embodiment.
FIG. 3 is a schematic configuration diagram of a second conveyance device, the bonder, and a load lock unit according to the first embodiment.
FIG. 4 is a view illustrating a part of the bonder according to the first embodiment.
FIG. 5 is an operation explanatory diagram of the bonder according to the first embodiment.
FIG. 6 is an operation explanatory diagram of the bonder according to the first embodiment.
FIG. 7A is a view illustrating a state where a holding portion of the second conveyance device according to the first embodiment is disposed in the bonder.
FIG. 7B is a view illustrating a state where a holding portion of the second conveyance device according to the first embodiment is disposed in the load lock unit.
FIG. 8 is a flowchart illustrating a flow of a bonding method according to the first embodiment.
FIG. 9A is a view illustrating the second conveyance device, the bonder, and the load lock unit according to the first embodiment, and illustrating a scene where the second conveyance device receives a substrate from the load lock unit.

FIG. 9B is a view illustrating the second conveyance device, the bonder, and the load lock unit according to the first embodiment, and illustrating a scene where the second conveyance device conveys the substrate to the bonder.

FIG. 10A is a view illustrating the second conveyance device, the bonder, and the load lock unit according to the first embodiment, and illustrating a state where the substrate is conveyed to the bonder.

FIG. 10B is a view illustrating the second conveyance device, the bonder, and the load lock unit according to the first embodiment, and illustrating a scene where the substrate is held by the head in the bonder.

FIG. 11A is a view illustrating the second conveyance device, the bonder, and the load lock unit according to the first embodiment, and illustrating a scene where the second conveyance device receives the substrate from the load lock unit.

FIG. 11B is a view illustrating the second conveyance device, the bonder, and the load lock unit according to the first embodiment, and illustrating a scene where the bonder receives the substrate from the second conveyance device.

FIG. 12A is a view illustrating the second conveyance device, the bonder, and the load lock unit according to the first embodiment, and illustrating a scene where the substrate is held on the stage in the bonder.

FIG. 12B is a view illustrating the second conveyance device, the bonder, and the load lock unit according to the first embodiment, and illustrating a scene of performing a bonding treatment in the bonder.

FIG. 13A is a view illustrating the second conveyance device, the bonder, and the load lock unit according to the first embodiment, and illustrating a scene where the second conveyance device receives the substrate from the bonder.

FIG. 13B is a view illustrating the second conveyance device, the bonder, and the load lock unit according to the first embodiment, and illustrating a scene where the second conveyance device conveys the substrate from the bonder to the load lock unit.

FIG. 14A is a view for explaining a measurement method of a bonding strength (converted to surface energy) of the substrate by a blade insertion method.

FIG. 14B is a view for explaining an evaluation method of a bonding strength according to an embodiment.

FIG. 15 is a view illustrating a relationship between the bonding strength of the substrates in the first embodiment and gas pressure in the chamber at the time of bonding.

FIG. 16 is a flowchart illustrating a flow of a hydrophilization bonding method according to a second embodiment of the present invention.

FIG. 17A is a photograph of two substrates bonded by the hydrophilization bonding method without performing a heat treatment process before an activation treatment process according to a comparative example.

FIG. 17B is a photograph of the two substrates bonded by the hydrophilization bonding method according to the second embodiment.

FIG. 18 is a schematic configuration diagram of a bonding system according to a modification.

FIG. 19 is a schematic configuration diagram of an activation treatment device according to the modification.

FIG. 20 is a flowchart illustrating a flow of a hydrophilization bonding method according to the modification.

FIG. 21 is a view illustrating a part of a bonder according to the modification.

FIG. 22 is a view illustrating a part of the bonder according to the modification.

FIG. 23 is a view illustrating a part of the bonder according to the modification.

FIG. 24A is a view illustrating a part of the bonder according to the modification.

FIG. 24B is a view illustrating a part of the bonder according to the modification.

Description of Embodiments

(First embodiment)

Hereinafter, the bonder according to the first embodiment of the present invention will be described with reference to the drawings. The bonder according to the present embodiment bonds two substrates by heating bonding surfaces of the two substrates in a chamber in a reduced-pressure atmosphere, then performing an activation treatment, and then bringing the substrates into contact with each other to pressurize and heat the substrates. Here, substrates W1 and W2 are bonded objects including any of, for example, a Si substrate, a glass substrate such as a $SiO_2$ glass substrate, an oxide substrate (e.g., a silicon oxide ($SiO_2$) substrate, an alumina substrate ($Al_2O_3$) including a sapphire substrate, a gallium oxide ($Ga_2O_3$), and the like), a nitride substrate (e.g., silicon nitride (SiN), aluminum nitride (AlN), and gallium nitride (GaN)), a GaAs substrate, a silicon carbide (SiC) substrate, a lithium tantalate (Lt:LiTaOs) substrate, a lithium niobate substrate (Ln:$LiNbO_3$), and a diamond substrate. Alternatively, the substrates W1 and W2 may be substrates provided with an electrode formed of a metal such as Au, Cu, Al, or Ti on the bonding surface. In the activation treatment, the bonding surface of the substrate is activated by irradiating, with a particle beam, the bonding surface of each of the two substrates to be bonded to each other.

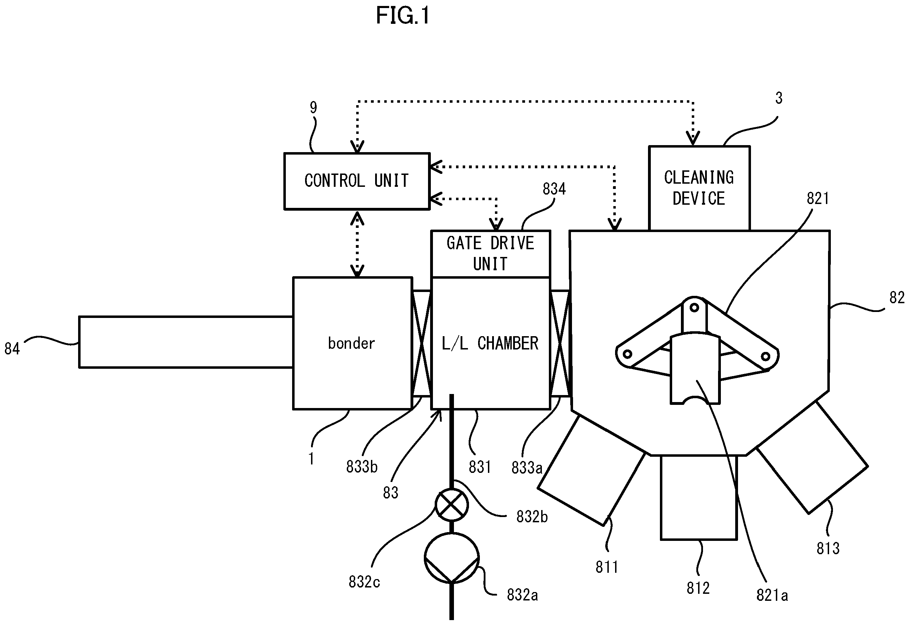

As illustrated in FIG. 1, the bonding system according to the present embodiment includes introduction ports 811 and 812, a takeout port 813, a first conveyance device 82, a cleaning device 3, a bonder 1, a load lock unit 83, a second conveyance device 84, and a control unit 9. The control unit 9 controls the first conveyance device 82, the cleaning device 3, the bonder 1, and the load lock unit 83. The first conveyance device 82 and the cleaning device 3 are provided with a high efficiency particulate air (HEPA) filter (not illustrated). Due to this, inside the first conveyance device 82 and the cleaning device 3 is in an atmospheric pressure environment with very few particles.

The first conveyance device 82 includes a conveyance robot 821 having an arm provided with a holding portion 821a holding a substrate at a tip end part. The conveyance robot 821 is movable along the arrangement direction of the introduction ports 811 and 812 and the takeout port 813, and can change the orientation of the tip end part of the arm by turning. The holding portion 821a has a vacuum chuck, an electrostatic chuck, and the like, and sucks and holds a side of the substrate opposite to the bonding surface side.

The cleaning device 3 cleans a conveyed substrate while discharging water, a cleaning liquid, or $N_2$ gas toward the substrate. The cleaning device 3 has a stage (not illustrated) supporting the substrate, a rotation drive unit (not illustrated) that rotates the stage in a plane orthogonal to the vertical direction, and a cleaning nozzle (not illustrated) that discharges water, a cleaning liquid, or $N_2$ gas to which ultrasonic waves or megasonic vibrations have been applied. Then, the cleaning device 3 cleans the entire surfaces of the bonding surfaces of the substrates W1 and W2 by rotating the stage while spraying, to the bonding surfaces of the substrates W1 and W2, water to which an ultrasonic wave is applied from the cleaning nozzle while swinging the cleaning nozzle in the radial direction of the substrates W1 and W2. Then, the cleaning device 3 spin-dries the substrates W1 and W2 by rotating the stage in a state of stopping the discharge of water by the cleaning nozzle.

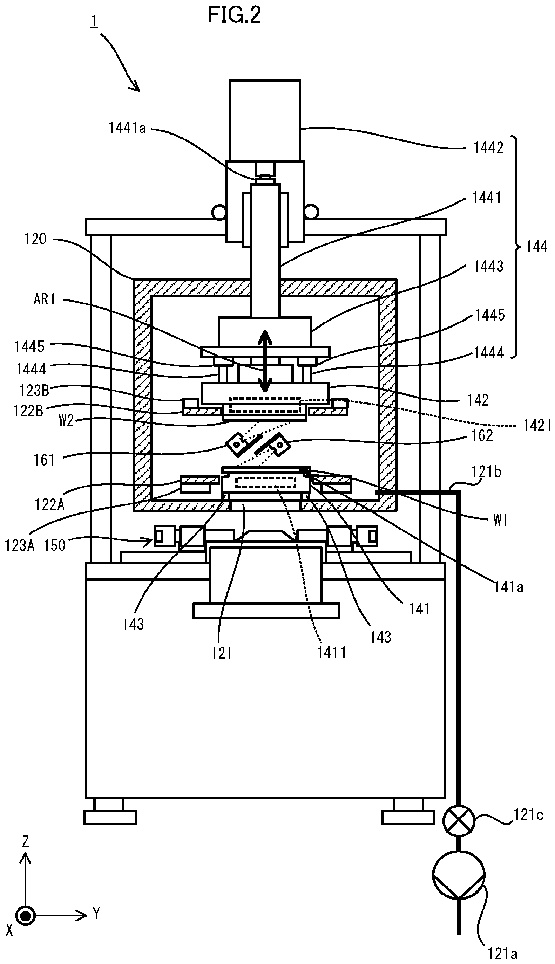

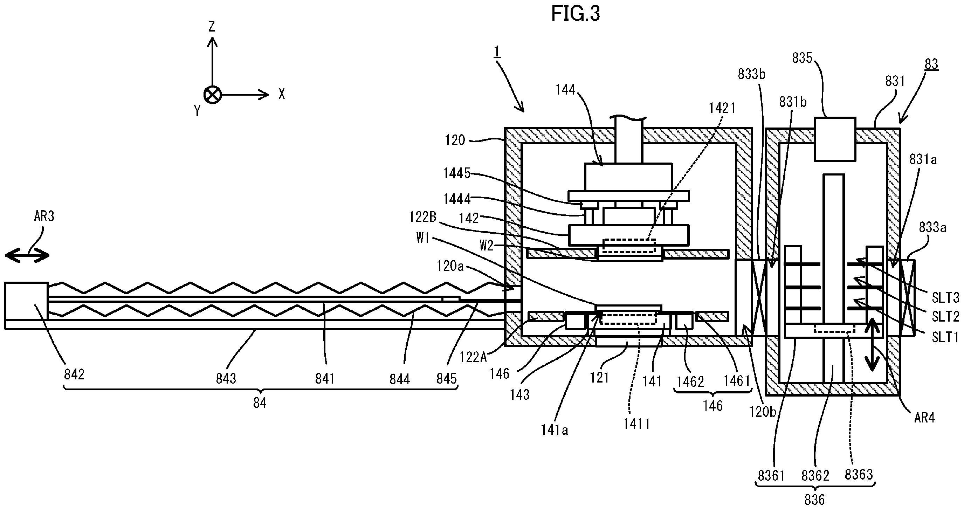

As illustrated in FIG. 2, the bonder 1 includes a chamber 120, a stage 141, a head 142, a stage drive unit 143, a head drive unit 144, substrate heating units 1411 and 1421, a positional displacement amount measurement unit 150, and particle beam sources 161 and 162. In the following description, the $\pm Z$ direction in FIG. 2 is defined as the up-down direction, and the XY direction is defined as the horizontal direction as appropriate. The bonder 1 includes covers 122A and 122B disposed in the chamber 120, and cover heating units 123A and 123B that heat the covers 122A and 122B. The covers 122A and 122B are disposed to include an activation treatment region in the activation treatment process around the stage 141 and the head 142, respectively. The cover heating units 123A and 123B are heaters fixed to the covers 122A and 122B on the side opposite to the particle beam sources 161 and 162, respectively. Furthermore, as illustrated in FIG. 3, the bonder 1 includes a support mechanism 146 disposed in the vicinity of the stage 141 and receiving the substrates W1 and W2 conveyed from the load lock unit 83 into the chamber 120. Returning to FIG. 2, the chamber 120 is connected to a vacuum pump 121a via an exhaust pipe 121b and the exhaust valve 121c. When the exhaust valve 121c is opened and the vacuum pump 121a is operated, the gas in the chamber 120 is discharged to the outside of the chamber 120 through the exhaust pipe 121b, and the gas pressure in the chamber 120 is reduced (decompressed). The gas pressure in the chamber 120 can be $10^{-5}$ Pa or less. The gas pressure (degree of vacuum) in the chamber 120 can be adjusted by varying the opening/closing amount of the exhaust valve 121c to adjust the exhaust amount.

The stage 141 and the head 142 are disposed in the chamber 120 so as to oppose each other in the Z direction. The stage 141 supports the substrate W1 on the upper surface of the stage 141, and the head 142 supports the substrate W2 on the lower surface of the head 142. Note that the upper surface of the stage 141 and the lower surface of the head 142 may be roughened in consideration of a case where the contact surfaces of the substrates W1 and W2 with the stage 141 and the head 142 are mirror surfaces and are hardly peeled off from the stage 141 and the head 142. The stage 141 and the head 142 each have a holding mechanism (not illustrated) that holds the substrates W1 and W2. The holding mechanism has an electrostatic chuck, a mechanical clamp, and the like. The stage 141 has a shape in which a step portion 141a is formed on a peripheral portion. Then, in a state where the substrates W1 and W2 are placed on the stage 141, the peripheral portions of the substrates W1 and W2 are disposed above the step portion 141a.

The stage drive unit 143 can move the stage 141 in the XY direction and rotate the stage around the Z axis. The head drive unit 144 has a lift drive unit 1441 that raises and lowers the head 142 as indicated by arrow AR1, an XY direction drive unit 1442 that moves the head 142 in the XY direction, and a rotation drive unit 1443 that rotates the head 142 in a rotation direction around the Z axis. The head drive unit 144 has a piezo actuator 1444 for adjusting an inclination of the head 142 with respect to the stage 141, and a pressure sensor 1445 for measuring the pressure applied to the head 142. The XY direction drive unit 1442 and the rotation drive unit 1443 move the head 142 relative to the stage 141 in the X direction, the Y direction, and the rotation direction around the Z axis, so that the substrate W1 held by the stage 141 and the substrate W2 held by the head 142 can be aligned. The stage drive unit 143 is not limited to the structure disposed vertically downward the stage 141. For example, a backup portion (not illustrated) that receives pressure may be provided vertically downward the stage 141, and the stage drive unit 143 may be disposed on the outer peripheral portion of the stage 141 to drive the stage 141 from the side of the stage 141.

The lift drive unit 1441 moves the head 142 vertically downward to bring the head 142 close to the stage 141. The lift drive unit 1441 moves the head 142 vertically upward to move the head 142 away from the stage 141. Then, when the lift drive unit 1441 applies a drive force in a direction approaching the stage 141 with respect to the head 142 in a state where the substrates W1 and W2 are in contact with each other, the substrate W2 is pressed against the substrate W1. The lift drive unit 1441 is provided with a pressure sensor 1441a that measures a drive force acting on the head 142 to a direction approaching the stage 141. The pressure acting on the bonding surfaces of the substrates W1 and W2 when the substrate W2 is pressed against the substrate W1 by the lift drive unit 1441 can be detected from the measurement value by the pressure sensor 1441a. The pressure sensor 1441a has, for example, a piezoelectric element.

A plurality of sets of the piezo actuator 1444 and the pressure sensor 1445 are disposed between the head 142 and the XY direction drive unit 1442. The pressure sensor 1445 is interposed between the upper end portion of the piezo actuator 1444 and the lower side of the XY direction drive unit 1442. Each of the piezo actuators 1444 can expand and contract in the up-down direction, and when these expand and contract, the inclination of the head 142 around the X axis and the Y axis and the position of the head 142 in the up-down direction are finely adjusted. The pressure sensor 1445 includes, for example, a piezoelectric element, and measures a pressurizing force at a plurality of positions on the lower surface of the head 142. Then, by driving each of the plurality of piezo actuators 411 so that the pressurizing forces measured by the plurality of pressure sensors 1445 are equalized, it is possible to bring the substrates W1 and W2 into contact with each other while maintaining the lower surface of the head 142 and the upper surface of the stage 141 in parallel.

For example, when the holding mechanism is an electrostatic chuck, the substrate heating units 1411 and 1421 are first bonded object heating units having an electrothermal heater embedded in the back side of the holding mechanism as viewed from the surface side of the stage 141 and the head 142 with which the substrates W1 and W2 are in contact. The substrate heating units 1411 and 1421 heat the substrates W1 and W2 by transferring heat to the substrates W1 and W2 supported by the stage 141 and the head 142. The temperature of the substrates W1 and W2 or the bonding surfaces thereof can be adjusted by adjusting the amount of heat generated by the substrate heating units 1411 and 1421. By recognizing the positions of alignment marks provided respectively on the substrates W1 and W2, the positional displacement amount measurement unit 150 measures the positional displacement amount of the substrate W1 with respect to the substrate W2 in the horizontal direction. The positional displacement amount measurement unit 150 recognizes the alignment marks of the substrates W1 and W2 using light (e.g., infrared light) transmitted through the substrates W1 and W2, for example. The stage drive unit 143 executes the alignment operation between the substrates W1 and W2 by moving or rotating the stage 141 in the horizontal direction based on the positional displacement amount measured by the positional displacement amount measurement unit 150. The measurement of the positional displacement amount by this positional displacement amount measurement unit 150 and the alignment operation of the stage drive unit 143 are both executed under the control of the control unit 9.

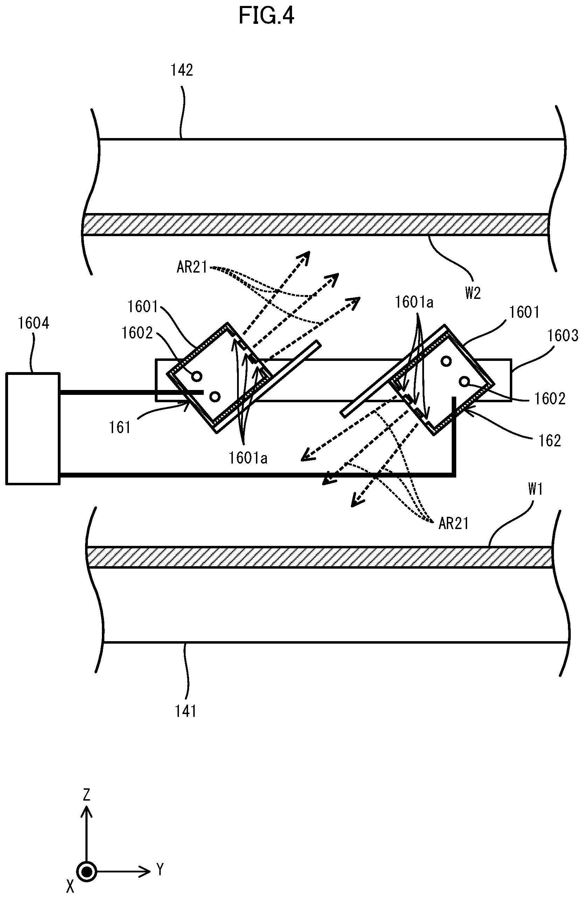

Each of the particle beam sources 161 and 162 is, for example, a fast atom beam (FAB) source, and is, as illustrated in FIG. 4, for example, an activation treatment unit including a discharge chamber 1601, an electrode 1602 disposed in the discharge chamber 1601, a beam source drive unit 1603, and a gas supply unit 1604 that supplies argon gas into the discharge chamber 1601. A peripheral wall of the discharge chamber 1601 is provided with a FAB radiation port 1601a through which neutral atoms are emitted. The discharge chamber 1601 is formed of a carbon material. Here, the discharge chamber 1601 has a long box shape, and a plurality of the FAB radiation ports 1601a are arranged side by side on a straight line along the long direction thereof. The beam source drive unit 1603 includes a plasma generation unit (not illustrated) that generates plasma of argon gas in the discharge chamber 1601, and a direct-current power source (not illustrated) that applies direct-current voltage between the electrode 1602 and the peripheral wall of the discharge chamber 1601. The beam source drive unit 1603 applies direct-current voltage between the peripheral wall of the discharge chamber 1601 and the electrode 1602 in a state of generating argon gas plasma in the discharge chamber 1601. At this time, argon ions in the plasma are attracted to the peripheral wall of the discharge chamber 1601. At this time, when passing through the FAB radiation port 1601a, argon ions traveling toward the FAB radiation port 1601a receive electrons from the peripheral wall of the discharge chamber 1601 formed of a carbon material on the outer peripheral portion of the FAB radiation port 1601a. Then, the argon ions become electrically neutralized argon atoms and are emitted to the outside of the discharge chamber 1601.

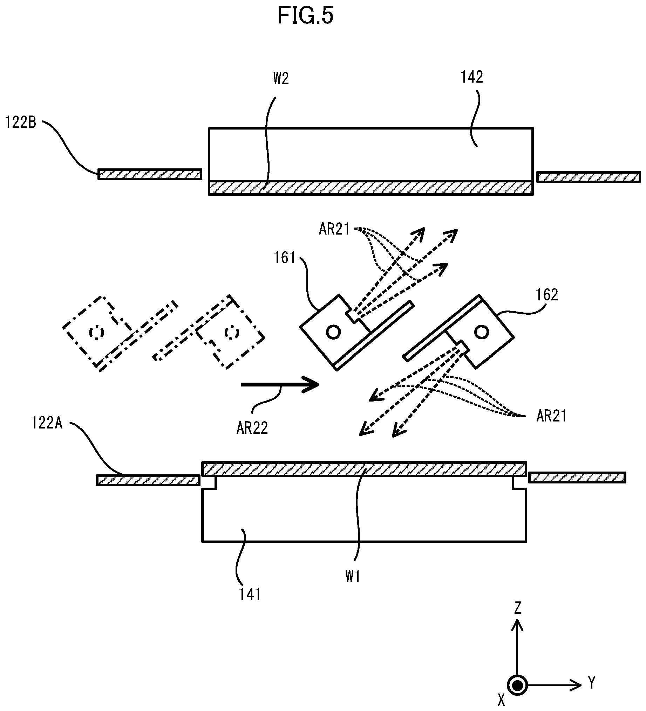

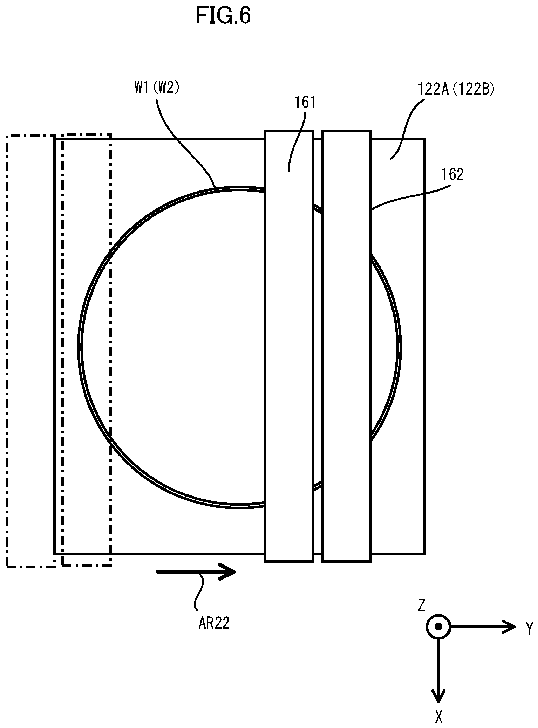

Here, for example, as illustrated in FIG. 5, the particle beam sources 161 and 162 move as indicated by arrow AR22 while irradiating the bonding surfaces of the substrates W1 and W2 with the particle beam as indicated by arrow AR21. Here, since there is a variation in strength in the movement direction of the particle beam alone in the projection plane, in order to reliably irradiate the entire substrates W1 and W2 with the particle beam, the particle beam sources 161 and 162 irradiate, with the particle beam, a region including the covers 122A and 122B parts outside both end edges of the substrate W1 in the movement direction of the particle beam sources 161 and 162. The strength of the particle beam at both end portions in the long direction of the discharge chamber 1601 of the particle beam source 161, that is, in the X axis direction tends to decrease. Therefore, as illustrated in FIG. 6, for example, the length of the discharge chamber 1601 in the X axis direction is set to a length that covers the entire substrates W1 and W2 in the X axis direction and is longer than the length of the substrates W1 and W2 in the X axis direction in a state of being disposed to overlap the substrates W1 and W2 in the Z axis direction. Alternatively, since the irradiation regions of the particle beam sources 161 and 162 are rectangular in plan view whereas the substrates W1 and W2 are circular in plan view, regions other than the substrates W1 and W2 are irradiated. Here, the bonder 1 irradiates the bonding surfaces of the substrates W1 and W2 with the particle beam while moving, for example, the particle beam sources 161 and 162 in the + Y direction as indicated by arrow AR22, and then irradiates the bonding surfaces of the substrates W1 and W2 with the particle beam while moving the particle beam sources 161 and 162 in the -Y direction. The moving speed of the particle beam sources 161 and 162 is set to, for example, 1.2 to 14.0 mm/sec. The power supplied to the particle beam sources 161 and 162 is set to, for example, 1 kV and 100 mA. The flow rate of the argon gas introduced into the discharge chamber 1601 of each of the particle beam sources 161 and 162 is set to, for example, 50 sccm.

Returning to FIG. 3, the covers 122A and 122B are formed of metal, for example, and are disposed around the stage 141 and the head 142 in the chamber 120, respectively. The cover heating unit 123A includes, for example, an electrothermal heater, and is disposed close to the cover 122A on the -Z direction side of the cover 122A. This cover 122A is fixed to the stage 141 and moves together with the stage 141. The cover heating unit 123B also includes, for example, an electrothermal heater, and is disposed close to the cover 122B on the +Z direction side of the cover 122B. This cover 122B is fixed to the head 142 and moves together with the head 142.

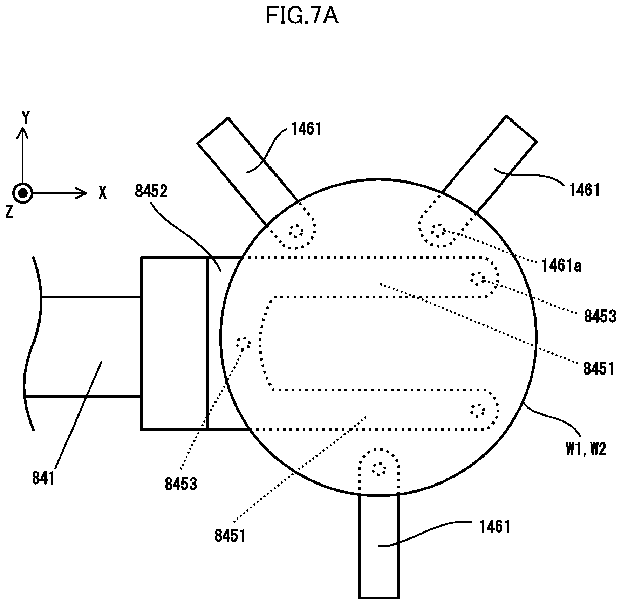

The support mechanism 146 includes a support member 1461 supporting the substrates W1 and W2, and a support member drive unit 1462 that raises and lowers the support member 1461. The support member 1462 has a substantially L shape, and a tip end part thereof extends to the step portion 141a formed on the peripheral portion of the stage 141. For example, three support mechanisms 146 are provided, and in this case, as illustrated in FIG. 7A, for example, the support member 1461 supports three positions in the peripheral portions of the substrates W1 and W2. A protrusion 1461a supporting the substrates W1 and W2 at the tip end part is disposed at the tip end part of the support member 1462. Then, as illustrated in FIG. 3, the support mechanism 146 lifts the substrates W1 and W2 by driving the support member 1462 in the +Z direction in a state where the tip end part of the support member 1462 comes into contact with the peripheral portions of the substrates W1 and W2 placed on the stage 141. This support mechanism 146 is fixed to the stage 141 and moves together with the stage 141.

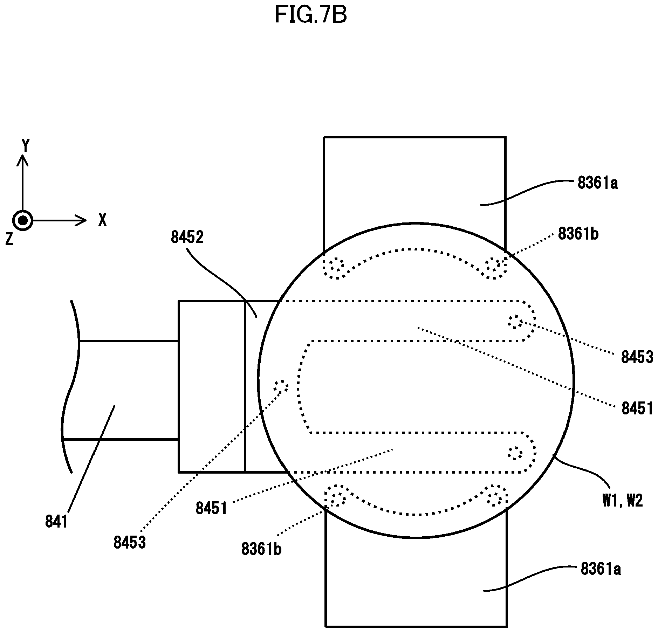

The load lock unit 83 includes a standby chamber 831, an exhaust pipe 832b communicating with the inside of the standby chamber 831, a vacuum pump 832a that discharges gas in the standby chamber 831 through the exhaust pipe 832b, and an exhaust valve 832c inserted in the exhaust pipe 832b. When the exhaust valve 832c is opened and the vacuum pump 832a is operated, the gas in the chamber 831 is discharged to the outside of the chamber 831 through the exhaust pipe 832b, and the gas pressure in the chamber 831 is reduced (decompressed). The gas pressure in the chamber 831 can be $10^{-2}$ Pa or less. The load lock unit 83 includes a gate 833a disposed on the first conveyance device 82 side in the standby chamber 831, a gate 833b disposed on the bonder 1 side in the standby chamber 831, and a gate drive unit 834 that individually opens and closes the gates 833a and 833b. The load lock unit 83 includes a substrate holding mechanism 836 that holds the substrates W1 and W2 conveyed into the standby chamber 831, and a substrate heating unit 835 that heats the substrates W1 and W2. The gates 833a and 833b are provided so as to cover an opening 831a penetrating on the first conveyance device 82 side in the standby chamber 831 and an opening 831b penetrating on the bonder 1 side in the standby chamber 831, respectively. The substrate holding mechanism 836 includes a cassette 8361 holding the substrates W1 and W2, a substrate heating unit 8363 that heats the substrates W1 and W2 held at the lowermost of the cassette 8361, and a lift drive unit 8362 that raises and lowers the cassette 8361 as indicated by arrow AR4. The cassette 8361 has a plurality of (three in FIG. 3) slots SLT1, SLT2, and SLT3. Then, the substrates W1 and W2 before bonding are held in the uppermost slot SLT3 and the lowermost slot SLT1, respectively, and the substrates W1 and W2 bonded to each other after the bonding process are held in the second slot from the uppermost, that is, the slot SLT2 in the center. This enables the heat treatment process by the substrate heating units 835 and 8363 of the substrates W1 and W2 in the load lock unit 83. Since the cassette 8361 can hold, in the slot SLT 2, the substrates W1 and W2 bonded to each other after the bonding treatment, after returning the substrates W1 and W2 bonded to each other after performing the bonding process in the bonder 1 to the slot SLT 2 in the center of the cassette 8361, the substrates W1 and W2 held in the slots SLT 1 and SLT 3 can be conveyed from the standby chamber 831 to the bonder 1 to perform the bonding process in the bonder 1. Due to this, while the bonder 1 is performing the bonding process, the standby chamber 831 is opened to the atmosphere, the substrates W1 and W2 bonded to each other are taken out, new substrates W1 and W2 can be conveyed into the standby chamber 831, it is not necessary to release the substrates to the atmosphere a plurality of times in one cycle, and it is possible to efficiently exchange the substrates one time during bonding, and therefore the treatment time can be shortened. Here, the substrate heating units 835 and 8363 are, for example, second bonded object heating units having a lamp heater. Note that the substrate heating unit 8363 may include, for example, an electrothermal heater. For example, as illustrated in FIG. 7B, the cassette 8361 includes support pieces 8361a supporting the peripheral portions of the substrates W1 and W2 from both sides of the substrates W1 and W2 in a direction orthogonal to the insertion direction of the substrates W1 and W2. A protrusion 8361b supporting the substrates W1 and W2 at the tip end part is disposed at the tip end part of the support pieces 8361a.

Returning to FIG. 3, the second conveyance device 84 includes a support rod 841 that is long, inserted into an opening 120a provided in the chamber 120 of the bonder 1, and provided with a holding portion 845 holding the substrates W1 and W2 in one end portion, a support 842 supporting the support rod 841 at the other end portion of the support rod 841, and a support drive unit 843 that drives the support 842. The second conveyance device 84 has a bellows 844 interposed between the outer peripheral portion of the opening 120a of the chamber 120 and the support 842 in order to maintain the degree of vacuum in the chamber 120. The support drive unit 843 includes, for example, a rail (not illustrated) slidably supporting, in the X axis direction, a slider (not illustrated) to which support 842 is fixed, and a ball screw mechanism (not illustrated) for driving the slide in the X axis direction. As indicated by arrow AR3, the support drive unit 843 drives the support 842 in a direction in which the support rod 841 is inserted into and removed from the chamber 120, thereby conveying the substrates W1 and W2 from one of the load lock unit 83 and the bonder 1 to the other. Here, for example, as illustrated in FIGS. 7A and 7B, the holding portion 845 includes a main portion 8452 and two long support pieces 8451 extending from the main portion 8452 in the same direction. A protrusion 8453 supporting the substrates W1 and W2 at the tip end part is disposed at each of the central portion of the main portion 8452 in the width direction and the tip end parts of the two support pieces 8451. The holding portion 845 has a size and a shape enough to be inserted between the two support mechanisms 146 of the bonder 1 and between the pair of support pieces 8361a of the cassette 8361 of the load lock unit 83.

Returning to FIG. 1, the control unit 9 is, for example, a programmable logic controller. Based on a measurement signal input from the pressure sensor 148, the positional displacement amount measurement unit 150, or the like, the control unit 9 calculates a pressure when the substrates W1 and W2 are brought into pressure contact with each other and calculates a relative positional displacement amount between the substrates W1 and W2. The control unit 9 outputs a control signal to the stage drive unit 143, the head drive unit 144, and the support mechanism 146 based on the calculated pressure or positional displacement amount, thereby controlling the operation of the stage drive unit 143, the head drive unit 144, and the support mechanism 146. Furthermore, by outputting control signals to the substrate heating units 1411 and 1421, the particle beam sources 161 and 162, the second conveyance device 84, and the first conveyance device 82, the control unit 9 controls the operation of them.

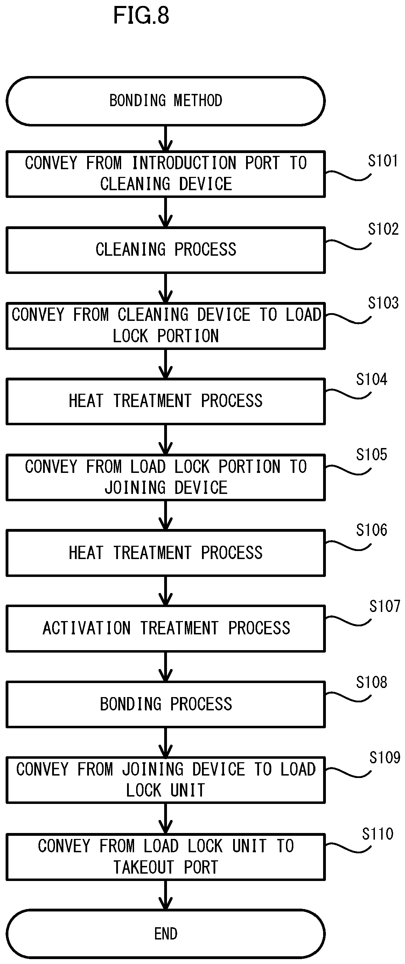

Next, a bonding method for bonding the substrates W1 and W2 using the bonding system according to the present embodiment will be described with reference to FIGS. 8 to 13. Here, it is assumed that the substrates W1 and W2 are disposed in the introduction ports 811 and 812 illustrated in FIG. 1 in a posture where the bonding surfaces are vertically upward. Note that in the introduction port 811, the substrate W2 held by the head 142 in the bonder 1, for example, is disposed, and in the introduction port 812, the substrate W1 placed on the stage 141 in the bonder 1, for example, is disposed. A chamber heating process of heating an inner wall of the chamber 120 is performed in advance before performing the bonding method according to the present embodiment. Specifically, a heater jacket (not illustrated) is wound around the peripheral wall of the chamber 120 to heat (bake) the inner wall of the chamber 120 at 150°C for about 24 hours in the chamber 120. Due to this, the gas pressure in the chamber 120 can be $10^{-5}$ Pa or less. At the time of baking this chamber 120, a cover heating process of simultaneously heating the covers 122A and 122B may be performed. Here, the length of the baking time for performing baking of the chamber 120 in the chamber heating process may be equal to or longer than the length of the cover heating time for heating the covers 122A and 122B in the cover heating process, or may be less than the length of the cover heating time. This can remove water or impurities adhering to the covers 122A and 122B. In particular, when the chamber 120 is baked, water or impurities desorbed from the chamber 120 adheres to the cover 122A having a relatively lower temperature than the chamber 120. In this case, when the activation treatment process is performed, the water or impurities adhering to the cover 122A is irradiated with the particle beam, and the water or impurities adhering to the cover 122 floats in the chamber 120 and adheres to the bonding surfaces of the substrates W1 and W2. Therefore, it is preferable to remove the water or impurities desorbed from the chamber 120 adhering to the cover 122A altogether by performing the cover heating process simultaneously with the baking of the chamber 120.

In the bonding method according to the present embodiment, as illustrated in FIG. 8, first, the first conveyance device 82 takes out the substrate W2 disposed in the introduction ports 811 and 812 and conveys the substrate W2 to the cleaning device 3 (step S101). Here, after taking out the substrates W1 and W2 from the introduction ports 811 and 812, the conveyance robot 821 turns so that the tip end part of the arm 821a faces the cleaning device 3 side in a state of holding the substrates W1 and W2. Next, when the cleaning device 3 opens conveyance inlets of the substrates W1 and W2, the conveyance robot 821 extends the arm 821a and inserts the tip end part of the arm 821a into the cleaning device 3. Then, the substrates W1 and W2 are transferred from the tip end part of the arm 821a of the conveyance robot 821 to the stage of the cleaning device 3.

Next, the cleaning device 3 executes the water cleaning process of cleaning the substrates W1 and W2 with water (step S102). Here, the cleaning device 3 cleans the entire bonding surfaces of the substrates W1 and W2 by rotating the stage on which the substrates W1 and W2 are placed while spraying water to which an ultrasonic wave is applied from the cleaning nozzle onto the bonding surfaces of the substrates W1 and W2. This removes foreign matters adhering to the bonding surfaces of the substrates W1 and W2. Next, after stopping discharge of water by the cleaning nozzle, the cleaning device 3 rotates the stage to spin dry the substrate, thereby completing the water cleaning process.

Thereafter, upon completing the series of cleaning treatment, the cleaning device 3 opens the conveyance inlets of the substrates W1 and W2.

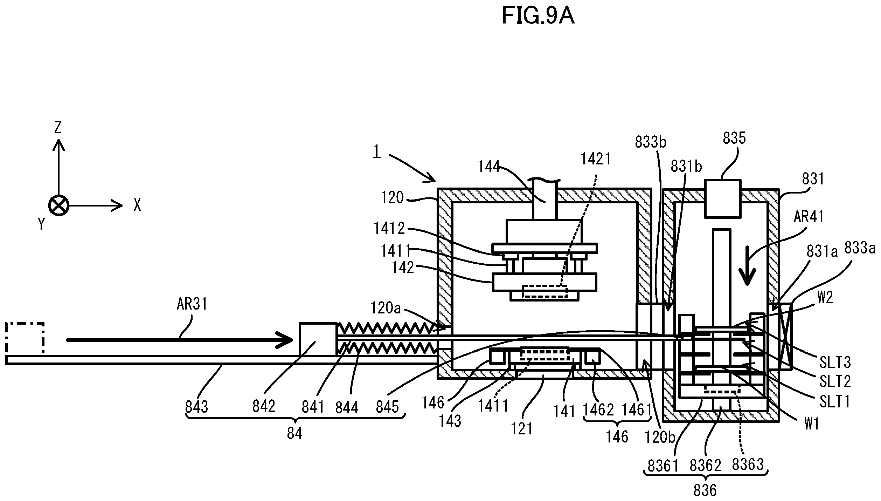

Subsequently, the first conveyance device 82 conveys the substrates W1 and W2, for which the water cleaning process has been completed, from the cleaning device 3 to the load lock unit 83 (step S 103). Here, the conveyance robot 821 of the first conveyance device 82 extends the arm 821a to insert the tip end part of the arm 821a into the cleaning device 3 in a state where the conveyance inlets of the substrates W1 and W2 of the cleaning device 3 are opened, and receives the substrates W1 and W2 from the stage in the cleaning device 3. Next, the conveyance robot 821 contracts the arm 821a, thereby taking out the substrates W1 and W2 from the cleaning device 3. Subsequently, when the gate drive unit 834 of the load lock unit 83 opens the gate 833a of the standby chamber 831 on the first conveyance device 82 side, the conveyance robot 821 turns so that the tip end part of the arm 821a faces the load lock unit 83 side in a state of holding the substrates W1 and W2. At this time, when receiving the substrate W2 from the cleaning device 3, the conveyance robot 821 turns in a state of holding the substrate W2 in a posture where the bonding surface of the substrate W2 faces vertically downward by reversing the arm 821a so that the bonding surface side of the substrate W2 faces vertically downward. On the other hand, when receiving the substrate W1 from the cleaning device 3, the conveyance robot 821 turns in a state of maintaining the posture of the substrate W2 in a posture where the bonding surface side faces vertically upward. Thereafter, the conveyance robot 821 extends the arm 821a to insert the tip end part of the arm 821a into the standby chamber 831. Then, the substrates W1 and W2 are transferred from the tip end part of the arm 821a to the cassette 8361 of the substrate holding mechanism 836 disposed in the standby chamber 831. At this time, for example, as illustrated in FIG. 9A, the substrates W1 and W2 are held in the uppermost slot SLT3 and the lowermost slot SLT1 of the cassette 8361. Next, upon completing the transfer of the substrates W1 and W2 to the cassette 8361 of the substrate holding mechanism 836, the conveyance robot 821 contracts the arm 821a. Then, the gate drive unit 834 closes the gate 833a of the standby chamber 831.

Returning to FIG. 8, thereafter, in the standby chamber 831 in a reduced-pressure atmosphere, a heat treatment process of heating the bonding surfaces to be bonded to each other of the two substrates W1 and W2 to a temperature higher than 60°C is performed (step S104). Here, the reduced-pressure atmosphere is, for example, a state where the gas pressure in the chamber 120 is $10^{-2}$ Pa or less. The substrate heating unit 835 of the load lock unit 83 heats the substrate W2, and the substrate heating unit 8363 heats the substrate W1. For example, the substrates W1 and W2 are heated by the substrate heating unit 835 disposed on the upper side of the standby chamber 831 and the substrate heating unit 8363 disposed on the lower side.

Next, the second conveyance device 84 conveys the substrates W1 and W2 held by the cassette 8361 of the substrate holding mechanism 836 from the load lock unit 83 to the bonder 1 (step S105). Here, the load lock unit 83 first decompresses the inside of the standby chamber 831 until the degree of vacuum becomes substantially the same as that of the chamber 120 of the bonder 1. Next, the gate drive unit 834 opens the gate 833b of the standby chamber 83 on the bonder 1 side. Subsequently, as illustrated in FIG. 9A, the lift drive unit 8362 of the load lock unit 83 moves the cassette 8361 to a position where the holding portion 845 of the second conveyance device 84 can be inserted to the lower side of the slot SLT3 holding the substrate W2.

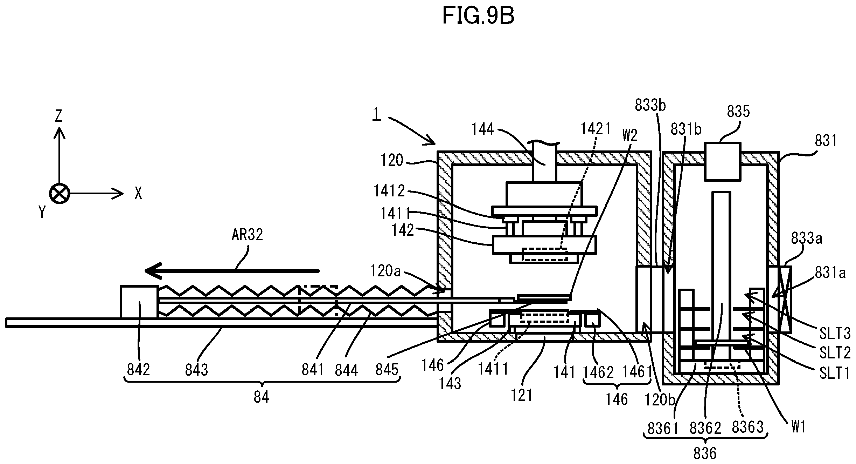

Thereafter, as indicated by arrow AR31, the second conveyance device 84 moves the support rod 841 to the load lock unit 83 side to insert the holding portion 845 to the lower side of the slot SLT3 holding the substrate W2 in the cassette 8361. Next, the lift drive unit 8362 of the load lock unit 83 moves the cassette 8361 vertically downward as indicated by arrow AR41, whereby the substrate W2 is transferred from the cassette 8361 to the holding portion 845. Here, the substrate W2 is held by the holding portion 845 in a posture where the bonding surface side of the substrate W2 faces vertically downward, but for example, as illustrated in FIGS. 4A and 4B, the holding portion 845 holds the outer peripheral portion of the bonding surface of the substrate W2 in point contact, and thus there is no influence on the bonding of the substrates W1 and W2. Subsequently, as indicated by arrow AR32 in FIG. 9B, the second conveyance device 84 moves the support rod 841 in a direction away from the load lock unit 83 to dispose the holding portion 845 in the chamber 120 of the bonder 1. Thereafter, the gate drive unit 834 closes the gate 833b.

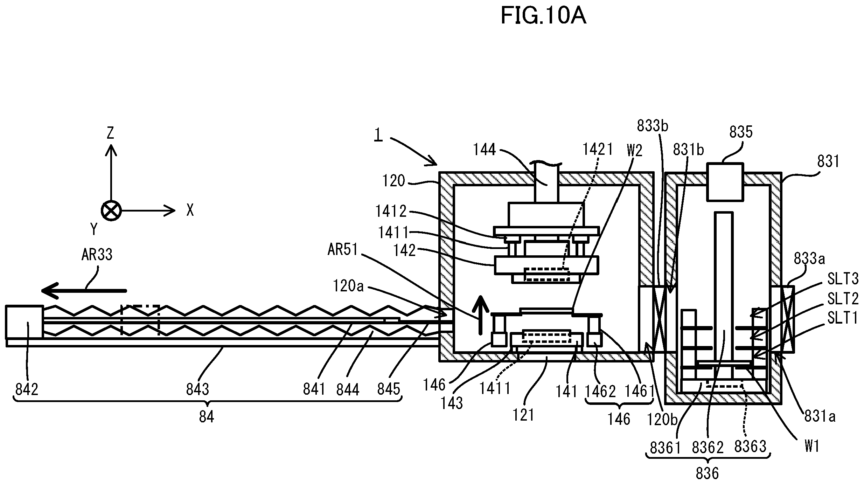

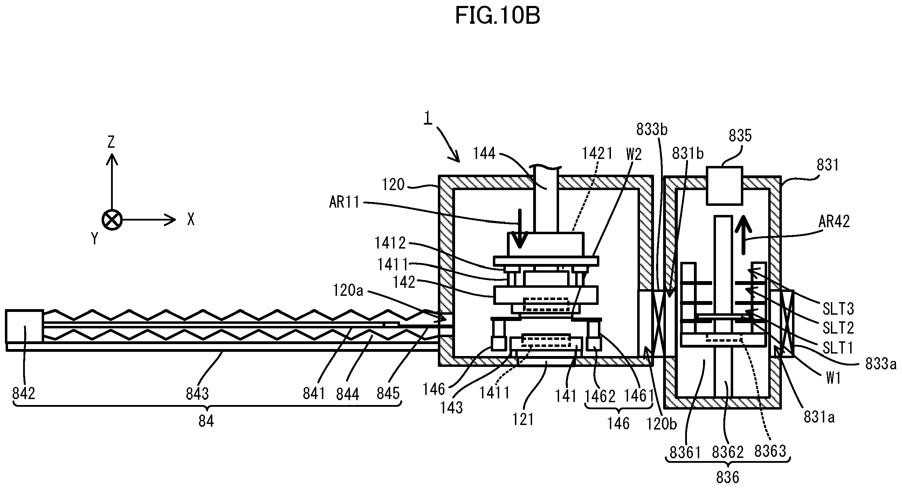

Next, as indicated by arrow AR51 in FIG. 10A, the support member drive unit 1462 of the support mechanism 146 lifts the substrate W2 by raising the support member 1461. Then, the second conveyance device 84 moves the support rod 841 in a direction away from the load lock unit 83 in a state where the substrate W2 is lifted by the support member 1461, thereby disposing the holding portion 845 at a preset standby position. Subsequently, as indicated by arrow AR11 in FIG. 10B, the head drive unit 144 of the bonder 1 moves the head 142 vertically downward to bring the head 142 into contact with the substrate W2 supported by the support member 1461 and then cause the head 142 to hold the substrate W2. Here, as indicated by arrow AR42, the load lock unit 83 moves the cassette 8361 to a position where the holding portion 845 of the second conveyance device 84 can be inserted to the lower side of the slot SLT1 holding the substrate W1.

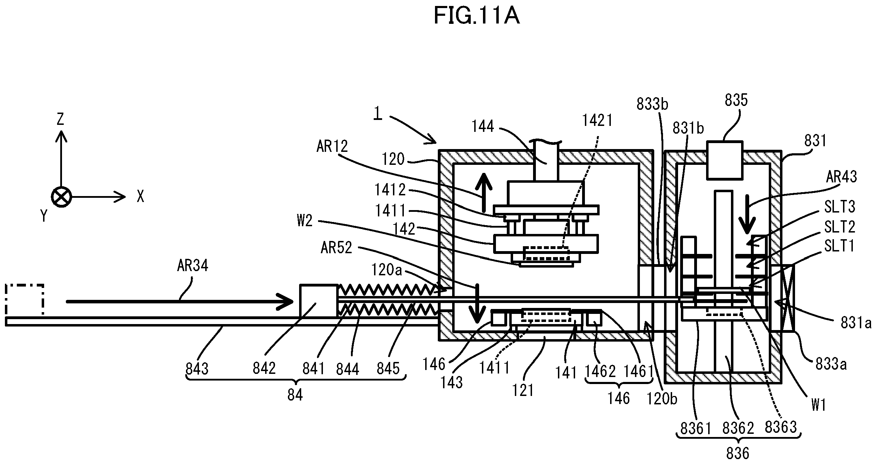

Thereafter, the head drive unit 144 raises the head 142 as indicated by arrow AR12 in FIG. 11A. At this time, the support member drive unit 1462 lowers the support member 1461 as indicated by arrow AR52. Next, the gate drive unit 834 opens the gate 833b of the standby chamber 83 on the bonder 1 side again. Subsequently, as indicated by arrow AR34, the second conveyance device 84 moves the support rod 841 to the load lock unit 83 side to insert the holding portion 845 to the lower side of the slot SLT1 holding the substrate W1 in the cassette 8361. Next, the lift drive unit 8362 of the load lock unit 83 moves the cassette 8361 vertically downward as indicated by arrow AR43, whereby the substrate W1 is transferred from the cassette 8361 to the holding portion 845.

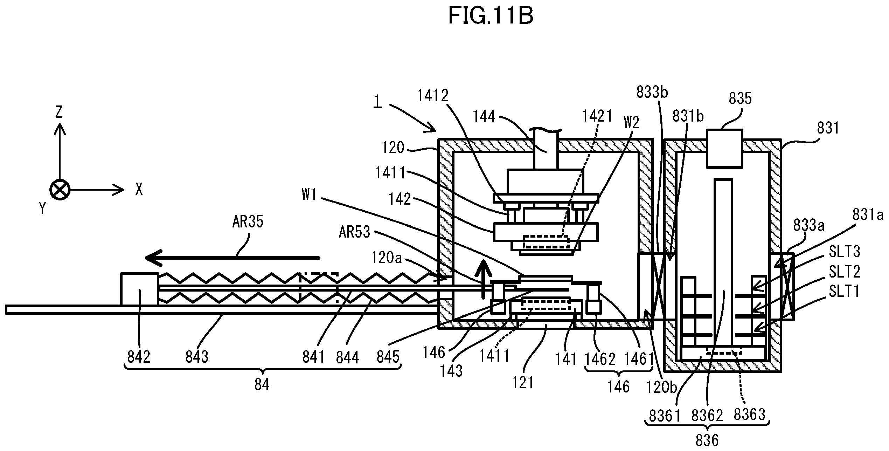

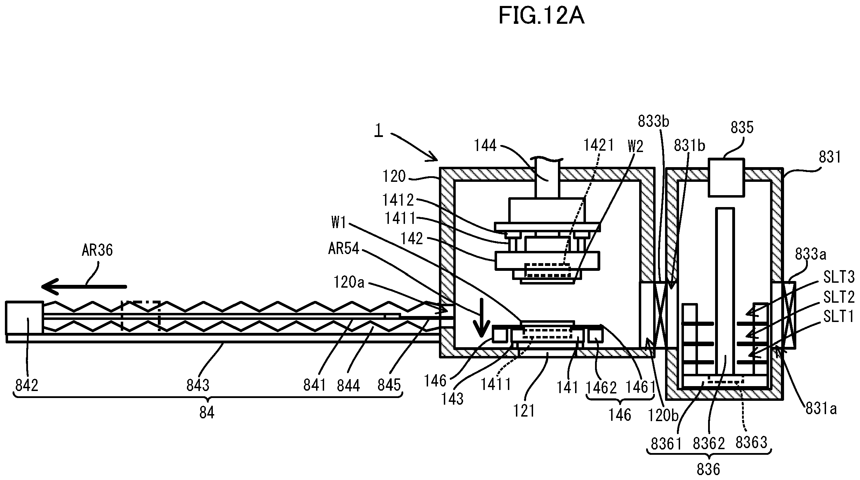

Subsequently, as indicated by arrow AR35 in FIG. 11B, the second conveyance device 84 moves the support rod 841 in a direction away from the load lock unit 83 to dispose the holding portion 845 in the chamber 120 of the bonder 1. Thereafter, the gate drive unit 834 closes the gate 833b. Next, the support member drive unit 1462 of the support mechanism 146 lifts the substrate W1 by raising the support member 1461 as indicated by arrow AR53. Then, the second conveyance device 84 moves the support rod 841 in a direction away from the load lock unit 83 as indicated by arrow AR36 in FIG. 12A in a state where the substrate W1 is lifted by the support member 1461, thereby disposing the holding portion 845 at a preset standby position. Next, as indicated by arrow AR54, the support member drive unit 1462 of the support mechanism 146 lowers the support member 1461 to place the substrate W1 on the stage 141, and then the stage 141 is brought into a state of being held on the substrate W1.

Returning to FIG. 8, next, the heat treatment process of heating the bonding surfaces to be bonded to each other of the two substrates W1 and W2 to a temperature higher than 60°C is performed in a reduced-pressure atmosphere (step S 106). Here, the reduced-pressure atmosphere is, for example, a state where the gas pressure in the chamber 120 is $10^{-6}$ Pa or less. The substrate heating units 1411 and 1421 heat the substrates W1 and W2 to a temperature higher than 60°C by transferring heat to the substrates W1 and W2 supported by the stage 141 and the head 142, respectively. This removes foreign matters mainly composed of water adhering to the bonding surfaces of the substrates W1 and W2.

Subsequently, an activation treatment process of activating the bonding surface of each of the two substrates W1 and W2 is performed in a reduced-pressure atmosphere (step S107). Here, as indicated by arrow AR21 in FIG. 5, the bonder 1 irradiates the bonding surfaces of the substrates W1 and W2 with the particle beams radiated from the particle beam sources 161 and 162, thereby performing activation treatment on the bonding surfaces of the substrates W1 and W2. After the heat treatment process and before the activation treatment process, a cooling process of cooling the substrates W1 and W2 to a temperature of 60°C or lower may be performed.

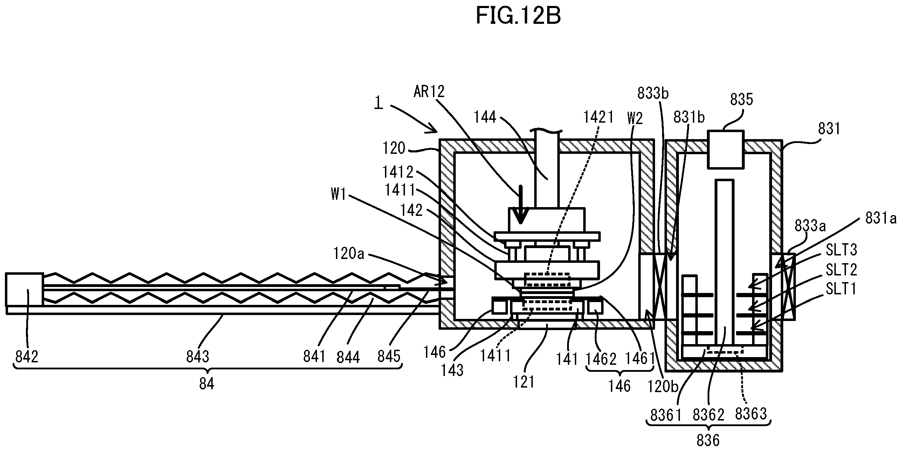

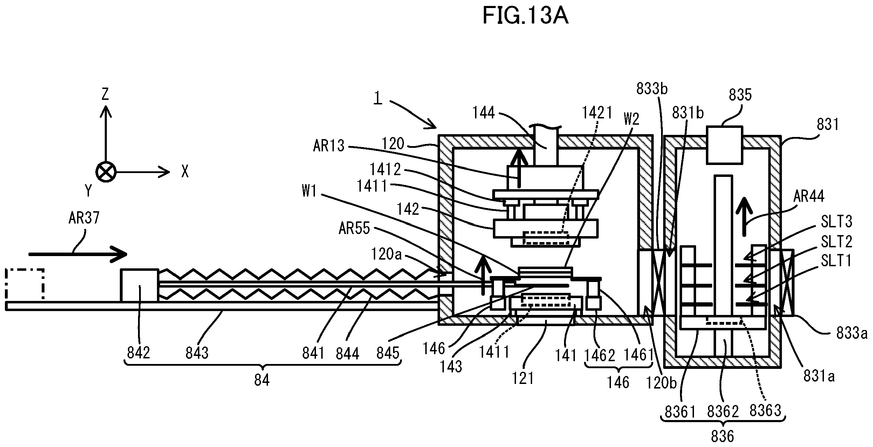

Returning to FIG. 8, thereafter, the bonding process of bonding the substrates W1 and W2 is performed (step S108). Here, the head drive unit 144 of the bonder 1 first brings the head 142 supporting the substrate W2 close to the stage 141 supporting the substrate W1 to bring the both substrates W1 and W2 close to each other. Subsequently, the head drive unit 144 executes the alignment operation of the both substrates W1 and W2 based on the positional displacement amount measured by the positional displacement amount measurement unit 150 in a state where the both substrates W1 and W2 are close to each other. In this manner, the head drive unit 144 executes the alignment operation after the activation treatment process, thereby reducing the positional displacement of the substrates W1 and W2. Thereafter, the head drive unit 144 brings the two substrates W1 and W2 into contact with each other by bringing the head 142 close to the stage 141 again as indicated by arrow AR12 in FIG. 12B. Next, the head drive unit 144 bonds the two substrates W1 and W2 by applying pressure in a direction in which the two substrates W1 and W2 are in close contact with each other in a state where the bonding surfaces of the substrates W1 and W2 are in contact with each other. Subsequently, after the holding of the substrate W2 by the head 142 is released, the head drive unit 144 raises the head 142 as indicated by arrow AR13 in FIG. 13A. At this time, the support member drive unit 1462 of the support mechanism 146 lifts the substrates W1 and W2 bonded to each other by raising the support member 1461 as indicated by arrow AR55. As indicated by arrow AR44, the load lock unit 83 moves the cassette 8361 to the second from the uppermost stage, that is, to a position where the holding portion 845 of the second conveyance device 84 can be inserted to the upper side of the slot SLT 2 in the center.

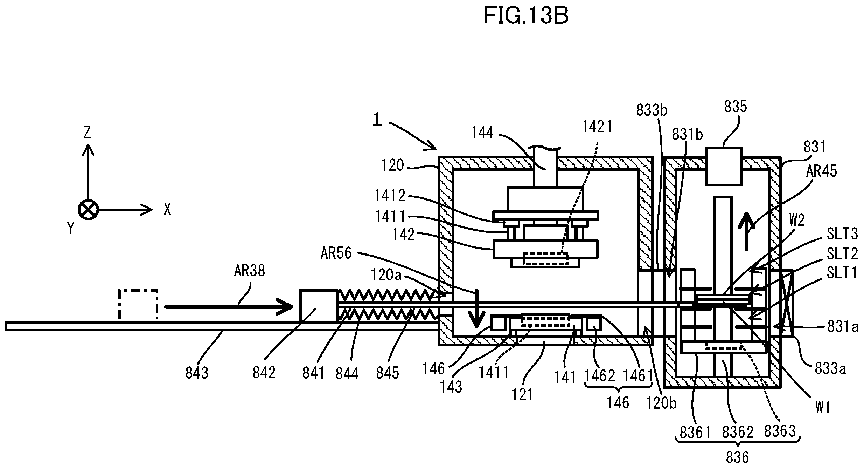

Returning to FIG. 7, next, the second conveyance device 84 conveys the substrates W1 and W2 bonded to each other from the bonder 1 to the load lock unit 83 (step S109). Here, first, the second conveyance device 84 moves the support rod 841 from the standby position in a direction approaching the load lock unit 83 as indicated by arrow AR37 in FIG. 13A, thereby disposing the holding portion 845 downward the substrates W1 and W2 in the chamber 120. Next, the gate drive unit 834 of the load lock unit 83 opens the gate 833b of the standby chamber 831 on the bonder 1 side. Subsequently, the support member drive unit 1462 of the support mechanism 146 lowers the support member 1461 as indicated by arrow AR56 in FIG. 13B, thereby transferring the substrates W1 and W2 bonded to each other to the holding portion 845. Thereafter, as indicated by arrow AR38, the second conveyance device 84 moves the support rod 841 from the standby position in a direction approaching the load lock unit 83, thereby inserting the holding portion 845 to the upper side of the slot SLT2 in the center of the cassette 8361. Then, as indicated by arrow AR45, the lift drive unit 8362 of the load lock unit 83 raises the cassette 8361 by a preset distance, whereby the substrates W1 and W2 are transferred from the holding portion 845 to the cassette 8361. Thereafter, the second conveyance device 84 moves the support rod 841 to the standby position. Next, the gate drive unit 834 closes the gate 833b.

Returning to FIG. 8, subsequently, the first conveyance device 84 conveys the substrates W1 and W2 bonded to each other from the load lock unit 83 to the takeout port 813 (step S110). Here, first, the load lock unit 83 opens the inside of the standby chamber 831 to the atmosphere. Next, the gate drive unit 834 of the load lock unit 83 opens the gate 833a of the standby chamber 831 on the first conveyance device 82 side, and the conveyance robot 821 extends the arm 821a in a state where the tip end part of the arm 821a faces the load lock unit 83 side, and inserts the tip end part of the arm 821a into the standby chamber 831. Then, the substrates W1 and W2 bonded to each other are transferred from the stage in the standby chamber 831 to the tip end part of the arm 821a of the conveyance robot 821. Next, after the conveyance robot 821 takes out, from the standby chamber 831, the substrates W1 and W2 bonded to each other by contracting the arm 821a, the gate drive unit 834 of the load lock unit 83 closes the gate 833a. Subsequently, the conveyance robot 821 turns so that the tip end part of the arm 821a faces the takeout port 813 side. Thereafter, in a state of holding the substrates W1 and W2 bonded to each other, the conveyance robot 821 extends the arm 821a, inserts the tip end part of the arm 821a into the takeout port 813, and disposes the substrates W1 and W2 bonded to each other into the takeout port 813.

Before performing the bonding method described above, a process of heating the chamber 120 in a state where the inside of the chamber 120 is decompressed, that is, the cover heating process of heating the covers 122A and 122B by the cover heating units 123A and 123B may be performed after the process of baking the chamber 120. Alternatively, before performing the above-described activation treatment process in which the substrates W1 and W2 are not yet disposed in the chamber 120, the cover heating process of heating the cover in a state where the inside of the chamber 120 is decompressed may be performed.

Next, the results of evaluating the bonding strength for 10 types of samples obtained by bonding the two substrates W1 and W2 by the bonding system according to the present embodiment will be described. For each sample, the supply amount of argon gas to each of the particle beam sources 161 and 162 in the activation treatment process was set to 50 sccm. The degree of vacuum in the chamber 120 immediately before irradiation of the substrates W1 and W2 with the particle beam from the particle beam sources 161 and 162 was set to $2 \times 10^{-6}$ Pa. When the substrates W1 and W2 were bonded to each other, a pressure of 20000 N was applied in a direction in which the two substrates W1 and W2 were in close contact with each other and maintained for 60 sec. As the substrates W1 and W2, a Si substrate was employed.

Table 1 below shows a summary of, for each of sample 1 to sample 7 among the 10 types of samples, the stage (head) temperature before the substrates W1 and W2 are held by the stage 141 and the head 142, the stage temperature immediately after the substrates W1 and W2 are conveyed from the load lock unit 83 to the stage 141 of the bonder 1, the temperature before contact in a separated state before the substrates W1 and W2 are brought into contact with each other, and the temperature after contact after the substrates W1 and W2 are brought into contact with each other. For samples 1 to 7, the standing time after the substrates W1 and W2 were conveyed from the load lock unit 83 to the stage 141 and the head 142 of the bonder 1 to the bonding process including the activation treatment process was performed was 30 sec for each. For samples 1 and 2, the stage 141 and the head 142 were heated to 300°C in a state before the substrates W1 and W2 were held by the stage 141 and the head 142, and then cooled to 25°C and 150°C, respectively. Thereafter, the substrates W1 and W2 were conveyed from the load lock unit 83 to the bonder 1. Furthermore, for sample 7, after the activation treatment, after the contact process was completed, the substrates W1 and W2 in contact with each other were heated to 150°C. Sample 3 was conveyed from the load lock unit 83 to the bonder 1, and then the temperatures of the stage 141 and the head 142 were raised to 150°C in a state where the opposing substrates were separated from each other, then the activation treatment was performed, and the substrates W1 and W2 were brought into contact with each other and bonded.

Table 1

|  | Stage heating temperature | Temperature immediately after conveyance to bonder | Temperature before contact | Temperature after contact |
|---|---|---|---|---|
| Sample 1 | 300°C | 25°C | 25°C | 25°C |
| Sample 2 | 300°C | 150°C | 150°C | 150°C |
| Sample 3 | 25°C | 25°C | 150°C | 150°C |
| Sample 4 | 60°C | 60°C | 60°C | 60°C |
| Sample 5 | 100°C | 100°C | 100°C | 100°C |

(continued)

|  | Stage heating temperature | Temperature immediately after conveyance to bonder | Temperature before contact | Temperature after contact |
|---|---|---|---|---|
| Sample 6 | 80°C | 80°C | 80°C | 80°C |
| Sample 7 | 25°C | 25°C | 25°C | 150°C |

Table 2 below shows a summary of, for each of samples 6 and 8 among the 10 types of samples, the standing time until the bonding process is performed after the substrates W1 and W2 were conveyed from the load lock unit 83 to the bonder 1. For sample 8, the temperatures of the stage 141 and the head 142 before the substrates W1, W2 were set on the stage 141 and the head 142 were 80°C similarly to sample 6. The temperature immediately after being conveyed from the load lock unit 83 to the bonder 1 and the temperature at the time of bonding of the substrates W1 and W2 were each set to 80°C similarly to sample 6.

Table 2

|  | Standing time |
|---|---|
| Sample 6 | 30 sec |
| Sample 8 | 10 min |

Furthermore, Table 3 below shows a summary of, for each of samples 9 and 10 among the 10 types of samples, the presence or absence of heat treatment after the substrates W1 and W2 were conveyed into the standby chamber 831. Here, "with heat treatment" means that heating was performed at 100°C for 10 minutes by the substrate heating unit 835 in the load lock unit 83. For each of samples 9 and 10, the standing time until the bonding process is performed after the substrates W1 and W2 were conveyed from the load lock unit 83 to the bonder 1 was 30 sec each. Furthermore, for samples 9 and 10, the temperatures of the stage 141 and the head 142 before the substrates W1 and W2 were set on the stage 141 and the head 142, the temperature immediately after the substrates W1 and W2 were conveyed from the load lock unit 83 to the bonder 1, and the temperature at the time of bonding the substrates W1 and W2 were all 25°C. The degree of vacuum in the standby chamber 831 of the load lock unit 83 was set to $10^{-2}$ Pa. Furthermore, the stage (head) temperature before the substrates W1 and W2 were held by the stage 141 and the head 142 of the bonder 1, the temperature immediately after the substrates W1 and W2 were conveyed from the load lock unit 83 to the bonder 1, and the temperature before contact and the temperature after contact were all set to normal temperature, that is, 25°C.

Table 3

|  | Heat treatment |
|---|---|
| Sample 9 | With |
| Sample 10 | Without |

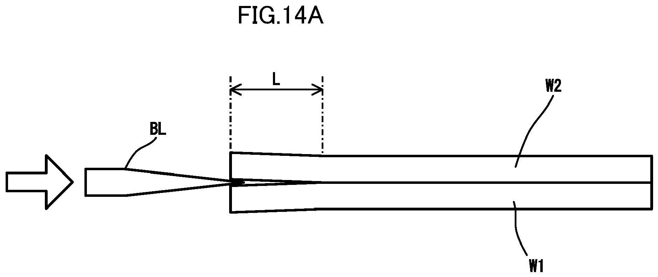

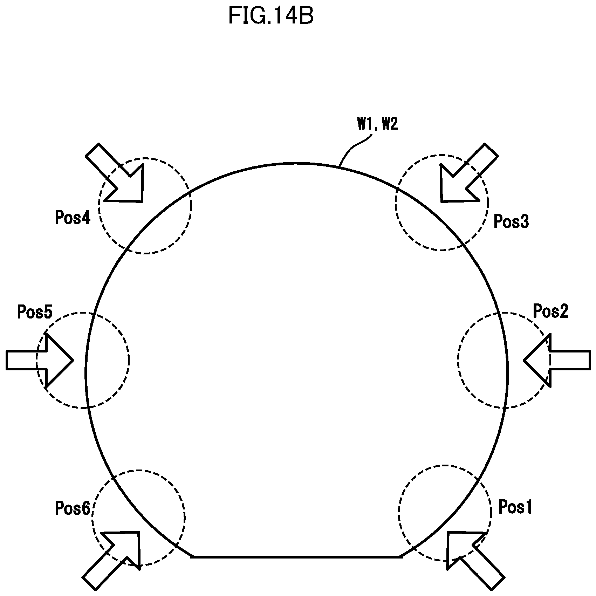

Evaluation of the bonding strength of the substrates W1 and W2 for samples 1 to 10 was performed by measuring the bonding strength (converted to surface energy) using a crack-and-opening method in which a blade is inserted. In this crack-and-opening method, first, as indicated by an arrow in FIG. 14A, a peeling length L of the substrates W1 and W2 when a blade BL such as a razor blade is inserted into the bonded portion from the peripheral edge of the two substrates W1 and W2 bonded to each other is measured. As the blade BL, a blade having a thickness of 100 $\mu$m, for example, is used. As illustrated in FIG. 14B, the peeling length L from the blade contact when the blade BL was inserted (see the arrow in FIG. 14B) to 6 positions (Pos1, Pos2, Pos3, Pos4, Pos5, and Pos6) in the peripheral edge portion of the two substrates W1 and W2 bonded to each other was measured. Then, the bonding strength of the substrates W1 and W2 was evaluated by calculating the strength of the bonding interface between the substrates W1 and W2 converted to surface energy per unit area from the peeling length L for each of the six peripheral portions of the substrates W1 and W2. When a bonding strength (converted to surface energy) Eb was calculated from the peeling length L, the relational expression of the following expression (1) was used.
[Mathematical expression 1]

[Mathematical expression 1]

$$Eb = \frac{3 \times Y \times Ts^3 \times Tb^2}{32 \times L^4} \qquad \cdots \text{Expression (1)}$$

Here, Y represents the Young's modulus, Ts represents the thickness of the substrates W1 and W2, and Tb represents the thickness of the blade BL. In the evaluation of the bonding strength of the substrates W1 and W2 for samples 1 to 14, the Young's modulus Y was $6.5 \times 10^{10}$ [N/m²], the thickness Ts of the substrates W1 and W2 was 0.0011 m (1.1 mm), and the thickness Tb of the blade BL was 0.0001 m (0.1 mm). The calculation expression indicates that the shorter the peeling length is, the larger the bonding strength becomes. Table 5 shows the average values of the peeling length and the bonding strength (converted to surface energy) at six positions in the peripheral edge portion of the substrates W1 and W2, and the number of measurement points where bulk fracture occurred. Note that the larger the calculated bonding strength (converted to surface energy) is, the larger the bonding strength of the substrates W1 and W2 is. Normally, bulk fracture exceeding 2 J/m² is preferable. Among those subjected to bulk fracture, it is assumed that the shorter the peeling length is, the higher the bonding strength is, and therefore the peeling length is also given.

Table 4 below shows the evaluation results of the bonding strength of the substrates W1 and W2 for samples 1 to 10. In Table 4, the column of "sample name" corresponds to each of sample 1 to sample 14 in Table 1 described above. The value in the column of "peeling length" indicates the average value of the peeling lengths at six positions ("Pos1" to "Pos6") in the peripheral edge portion of the two substrates W1 and W2 illustrated in FIG. 14B. The value in the column of "bonding strength (converted to surface energy)" indicates the average value of the bonding strength (converted to surface energy) at six positions ("Pos1" to "Pos6") in the peripheral edge portion of the two substrates W1 and W2 illustrated in FIG. 14B, and those with bulk fracture occurring at all of the six positions in the peripheral edge portion of the two substrates W1 and W2 are described as "bulk fracture". Note that the numerical values in parentheses in the columns of "bonding strength (converted to surface energy)" corresponding to samples 2, 3, 5, 6, 8, and 9 are theoretical values calculated using expression (1) from the average value of the peeling lengths, and are values that do not actually exist but are described for reference. Furthermore, the value in the column of "number of bulk fracture positions" indicates the number of positions where bulk fracture has occurred among the six positions in the peripheral edge portion of the two substrates W1 and W2.

Table 4

| Sample name | Peeling length (mm) | Bonding strength (converted to surface energy) (J/m²) | Number of bulk fracture positions |
|---|---|---|---|
| Sample 1 | 11.6 | 2.15 | 0 |
| Sample 2 | 1.2 | > 2.5 (20879.06) | 6 |
| Sample 3 | 1.3 | > 2.5 (12238.92) | 6 |
| Sample 4 | 12.8 | 1.46 | 1 |
| Sample 5 | 1.7 | > 2.5 (5013.06) | 0 |
| Sample 6 | 9.9 | > 2.5 (4.00) | 2 |
| Sample 7 | 11.3 | 2.41 | 2 |
| Sample 8 | 6.7 | > 2.5 (19.58) | 4 |
| Sample 9 | 8.7 | > 2.5 (3.08) | 2 |
| Sample 10 | 10.1 | 1.68 | 0 |

As illustrated in Table 4, the bonding strength (converted to surface energy) of each of samples 2 and 3 was 2.5 J/m² or more, and the bulk fracture strength was satisfied at all of the six positions, whereas the bonding strength (converted to surface energy) of each of samples 1 and 7 was less than 2.5 J/m². On the other hand, the result of sample 3 indicates that even when these temperatures before the substrates W1 and W2 were held by the stage 141 and the head 142 are maintained at normal temperature, that is, about 25°C, the bonding strength of the substrates W1 and W2 is greatly increased by increasing the temperature immediately after being conveyed from the load lock unit 83 to the bonder 1 and the temperature before contact to 150°C. These results indicate that performing baking by increasing the temperatures of the substrates W1 and W2 to 300°C before the substrates W1 and W2 are held by the stage 141 and the head 142 does not contribute to improvement in the bonding strength of the substrates W1 and W2. It is found that heating the substrates W1 and W2 to 150°C after bringing the substrates W1 and W2 into contact with each other does not contribute to improvement in the bonding strength of the substrates W1 and W2 either. That is, it is found that increasing the temperature immediately after being conveyed from the load lock unit 83 to the bonder 1 and the temperature before contact of the substrates W1 and W2 contributes to improvement in the bonding strength of the substrates W1 and W2. That is, it is found that performing the heat treatment process immediately before performing the activation treatment process is important in increasing the bonding strength of the substrates W1 and W2.

The bonding strength (converted to surface energy) of sample 4 was less than 2.5 J/m$^2$, whereas the bonding strength (converted to surface energy) of samples 3, 5, and 6 was 2.5 J/m$^2$ or more. In particular, in samples 3 and 5, all six positions reached the bulk fracture strength. These results indicate that the bonding strength of the substrates W1 and W2 is increased by increasing the temperature immediately after being conveyed from the load lock unit 83 to the bonder 1, that is, the temperature immediately before bonding and the temperature at the time of bonding of the substrates W1 and W2 to a temperature higher than 60°C, and particularly, the bonding strength of the substrates W1 and W2 is greatly increased by increasing the temperature immediately before bonding of the substrates W1 and W2 to a temperature of 100°C or higher.

Furthermore, while the bulk fracture strength of sample 6 was reached at two positions, the bulk fracture strength of sample 8 was reached at four positions. This result indicates that when these temperatures before the substrates W1 and W2 are held by the stage 141 and the head 142, that is, the temperature immediately before bonding of the substrates W1 and W2 is 80°C, the bonding strength of the substrates W1 and W2 is improved by increasing the standing time until the bonding process is performed after the substrates W1 and W2 are conveyed from the load lock unit 83 to the bonder 1.

The bonding strength (converted to surface energy) of sample 10 was less than 2.5 J/m$^2$, whereas the bonding strength (converted to surface energy) of sample 9 was 2.5 J/m$^2$ or more, which reached the bulk fracture strength at two positions. This indicates that heating the substrates W1 and W2 in the load lock unit 83 also contributes to improvement in the bonding strength of the substrates W1 and W2. It was also found that the gas pressure in the heat treatment process is sufficient to be 10$^{-2}$ Pa or less. The bonding strength of sample 9 is lower than the bonding strength of sample 5. This indicates that the gas pressure in the heat treatment process is more preferably 10$^{-5}$ Pa or less. This is considered to reflect the fact that more impurities mainly composed of water molecules adhering to the surfaces of the substrates W1 and W2 were removed and readhesion was prevented. It is considered that this is because moisture and impurities are contained in the atmosphere at about 10$^{-2}$ Pa as compared with 10$^{-5}$ Pa or less.

The principle of performing direct bonding by the present activation treatment is that Ar particle beam removes impurities on the surface, the dangling bond to become an atomic bonding is exposed by removing molecular bonding, and in an environment where molecules to become other impurities are not floating, the dangling bonds of the other substrates can be directly bonded to each other at room temperature. Therefore, at the degree of vacuum at which impurities float, the dangling bond is terminated by the impurities and cannot be bonded.

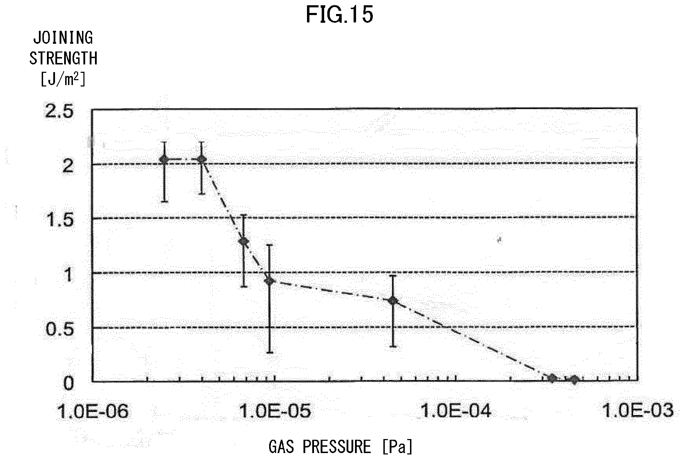

The bonding strength (converted to surface energy) of the substrates W1 and W2 shows dependency on the gas pressure in the chamber 120 in the activation treatment process, for example, as illustrated in FIG. 15. The results illustrated in FIG. 15 are results when both the substrates W1 and W2 are Si substrates. From the results illustrated in FIG. 15, the strength of the gas pressure in the chamber 120 in the activation treatment process rapidly increases from 10$^{-5}$ Pa or less. The inside of the chamber 120 becomes 10$^{-5}$ Pa or less as follows. A heater jacket (not illustrated) is wound around the peripheral wall of the chamber 120, and the inside of the chamber 120 is subjected to heat treatment (baking) at 150°C for about 24 hours, thereby removing impurities mainly of moisture in the chamber 120. The result as illustrated in FIG. 15 is considered to indicate that when the gas pressure in the chamber 120 is 10$^{-5}$ Pa or less, impurities mainly composed of moisture floating in the chamber 120 are removed in the heat treatment process, not adhering to the substrates W1 and W2, and the bonding strength of the substrates W1 and W2 is improved. However, since the substrates W1 and W2 themselves are conveyed from the atmosphere, impurities mainly containing moisture adhere to the surfaces thereof, and it is preferable to remove and bond the substrates W1 and W2. This also suggests that before bonding the substrates W1 and W2 to each other, impurities mainly containing moisture can be removed by similarly subjecting the substrates W1 and W2 themselves to heat treatment, and therefore the bonding strength of the substrates W1 and W2 is further improved.

In samples 1 to 10, a Si substrate is adopted as the substrates W1 and W2, but as the substrates W1 and W2, for example, a glass substrate such as a SiO$_2$ glass substrate, an oxide substrate (e.g., a silicon oxide (SiO$_2$) substrate, an alumina substrate (Al$_2$O$_3$) including a sapphire substrate, a gallium oxide (Ga$_2$O$_3$), and the like), a nitride substrate (e.g., silicon nitride (SiN), aluminum nitride (AlN), and gallium nitride (GaN)), a GaAs substrate, a silicon carbide (SiC) substrate, a lithium tantalate (Lt:LiTaO$_3$) substrate, a lithium niobate (Ln:LiNbO$_3$) substrate, and a diamond substrate may be adopted. Even in various substrates in which the bonding surfaces of the substrates W1 and W2 are provided with electrodes formed of a metal such as Au, Cu, Al, or Ti, it is considered that the effect of removing impurities mainly composed of water molecules adhering to the surfaces of the substrates W1 and W2 in the heat treatment process as described above can be obtained.

A case where the substrates W1 and W2 formed of materials having different linear expansion coefficients were bonded to each other was also evaluated. The above-described bonding method was performed by adopting a Si substrate as the substrate W1 and a lithium tantalate (Lt:LiTaO$_3$) substrate or a lithium niobate substrate (Ln:LiNbO$_3$) as the substrate W2. Here, when the substrates W1 and W2 were bonded to each other in a state where the temperature of the substrates W1 and W2 was maintained at 100°C after the substrates W1 and W2 were subjected to heat treatment at 100°C, the bonding strength (converted to surface energy) of the substrates W1 and W2 was 1.0 J/m$^2$. On the other hand, when the substrates W1 and W2 were bonded to each other after the substrates W1 and W2 were subjected to heat treatment at 100°C and then the temperature of the substrates W1 and W2 was cooled to 60°C, the bonding strength (converted to surface energy) of the substrates W1 and W2 increased to 1.6 J/m$^2$. That is, the bonding strength of the substrates W1 and W2 was improved when the substrates W1 and W2 were bonded to each other after the temperature of the substrates W1 and W2 decreased to a temperature lower than the temperature during the heat treatment after the heat treatment. This is considered to indicate that when the substrates W1 and W2 are bonded to each other in a state where the substrates W1 and W2 are maintained at a relatively high temperature during the heat treatment, a difference occurs in the degree of expansion due to heat expansion of the substrates W1 and W2 due to a difference in linear expansion coefficients between the substrates W1 and W2, a force is applied to the substrates W1 and W2 in a direction in which the substrate W1 is peeled off from the substrate W2, warpage or cracking of the substrates W1 and W2 occurs, and not just that, the bonding strength of the substrates W1 and W2 is reduced. Therefore, when two substrates W1 and W2 made of materials having different linear expansion coefficients are bonded to each other, it is preferable to bond the substrates W1 and W2 to each other after cooling the substrates W1 and W2 after the heat treatment process.

Water cleaning was performed in the cleaning device 3, water adhering to the bonding surfaces of the substrates W1 and W2 was removed by a spin dry method and then immediately conveyed into the load lock unit 83, and then the substrates W1 and W2 were bonded without performing the heat treatment process. In this case, the bonding strength (converted to surface energy) of the substrates W1 and W2 was 0.5 J/m$^2$ or less. On the other hand, in the case where water cleaning was performed in the cleaning device 3, water adhering to the bonding surfaces of the substrates W1 and W2 was removed by a spin dry method and then conveyed into the load lock unit 83, and the heat treatment process of maintaining at the temperature of 100°C for 30 sec in the load lock unit 83 or the bonder 1, the bonding strength (converted to surface energy) of the substrates W1 and W2 became larger than 2.5 J/m$^2$. That is, also by performing water cleaning before the bonding treatment, it was possible to improve the bonding strength of the substrates W1 and W2. This is considered to be because water is removed by the spin dry method after water cleaning in the cleaning device 3, but in a case where the heat treatment process of the substrates W1 and W2 is not performed, water molecules remain as thin layers on the bonding surfaces of the substrates W1 and W2, and due to this, the bonding strength of the substrates W1 and W2 is reduced as compared with the bonding strength of the substrates W1 and W2 in a case where water cleaning is not performed. On the other hand, it is considered that by performing the heat treatment process of the substrates W1 and W2, substantially all of the water remaining on the bonding surfaces of the substrates W1 and W2 is removed, so that the bonding strength of the substrates W1 and W2 is improved. This result suggests that, when water remains on the bonding surfaces of the substrates W1 and W2, the water remaining on the substrates W1 and W2 does not completely disappear only by leaving the substrates W1 and W in a vacuum atmosphere. Also in the vacuum atmosphere, water remains on the bonding surfaces of the substrates W1 and W2, and this result indicates that it is effective to heat the substrates W1 and W2 in the vacuum atmosphere in order to completely remove the water.

Furthermore, the Si substrate was used as the substrates W1 and W2, and a temporal change in bonding strength when the substrates W1 and W2 were bonded to each other after the bonding surfaces of the substrates W1 and W2 were irradiated with the particle beam was compared between the case where the heat treatment process was performed and the case where the heat treatment process was not performed. In the irradiation with the particle beam, the number of times of irradiation was reduced in order to decrease the bonding strength of the substrates W1 and W2 to some extent and easily confirm the temporal change in the bonding strength of the substrates W1 and W2. As a result, the bonding strength of the substrates W1 and W2 when the heat treatment process was performed was about twice or more as compared with that when the heat treatment process was not performed.

As described above, in the bonding system according to the present embodiment, in the bonder 1, in a state where the two substrates W1 and W2 are separated from each other, the heat treatment process of heating the bonding surface of each of the two substrates W1 and W2 to a temperature higher than 60°C in a reduced-pressure atmosphere is performed, and then the activation treatment process of activating the bonding surfaces of the substrates W1 and W2 is performed. Thereafter, the bonder 1 bonds the two substrates W1 and W2 in a reduced-pressure atmosphere. Due to this, by heating the bonding surface of each of the two substrates W1 and W2 to a temperature higher than 60°C in a reduced-pressure atmosphere, water or impurities present on the bonding surfaces of the substrates W1 and W2 are vaporized and removed, and therefore the bonding surfaces of the substrates W1 and W2 is easily activated by the activation treatment. Therefore, the bonding strength of the two substrates W1 and W2 when the two substrates W1 and W2 after the activation treatment are bonded can be increased.

As a method for removing impurities adhering to the bonding surfaces of the substrates W1 and W2, it is conceivable to remove the impurities by irradiating with a particle beam. In this case, a direct-current voltage applied between the electrodes 1602 of the particle beam sources 161 and 162 and the peripheral wall of the discharge chamber 1601 is set to 1 kV, a current value flowing between the electrodes 1602 and the peripheral wall of the discharge chamber 1601 is set to 100 mA, an Ar gas flow rate to be introduced into the discharge chamber 1601 is set to 50 sccm, and the bonding surfaces of the substrates W1 and W2 are continuously irradiated with the particle beam. However, in the case of this method, it is necessary to irradiate the bonding surfaces of the substrates W1 and W2 with an extra particle beam in order to remove impurities, and the irradiation time of the particle beam becomes longer accordingly. For example, in a case where impurities having a thickness of about several nm are adhering to the bonding surfaces of the substrates W1 and W2, the time for irradiating the particle beam becomes longer by about 5 minutes. It is difficult to set the irradiation time of the particle beam necessary for removing the impurities because the impurities adhering to the bonding surfaces of the substrates W1 and W2 have variations in thickness or adhesion strength. For this reason, there is a case where the bonding surfaces of the substrates W1 and W2 are irradiated with the particle beam more than necessary. In this case, the substrates W1 and W2 are scraped by the particle beam, the flatness of the bonding surface is impaired, and as a result, the bonding strength of the substrates W1 and W2 is reduced.

On the other hand, in the bonding method according to the present embodiment, the bonding surface of each of the two substrates W1 and W2 is heated to a temperature higher than 60°C before the activation treatment, thereby removing impurities present on the bonding surfaces of the substrates W1 and W2. Due to this, in the activation treatment, the bonding surfaces of the substrates W1 and W2 are etched by about 1 nm, that is, by a thickness corresponding to one atomic layer exposed to the bonding surfaces of the substrates W1 and W2 only by irradiating with the particle beam for about 2 to 3 minutes, and the dangling bond necessary for enhancing the bonding of the substrates W1 and W2 can be exposed while maintaining the flatness of the bonding surfaces of the substrates W1 and W2. Therefore, the bonding strength of the substrates W1 and W2 can be increased.

Since the substrates W1 and W2 are input from the atmosphere, moisture and impurities adhere to the bonding surfaces of the substrates W1 and W2. Therefore, it is considered that impurities mainly composed of water molecules adhere to the surfaces of the substrates W1 and W2. On the other hand, in the bonding method according to the present embodiment, since the substrates W1 and W2 are heated before the activation treatment, when impurities mainly composed of water molecules adhere to the substrates W1 and W2, they can be effectively removed. In particular, since water is crystallized in a reduced-pressure atmosphere, the water can be vaporized (sublimated) and easily removed by heating the substrates W1 and W2. From the experimental results, it is considered that the impurities are mainly moisture since the impurities are removed at around 100°C. That is, impurities mainly composed of water molecules are preferably removed by heating in a reduced-pressure atmosphere rather than by a removal method by etching such as irradiation with a particle beam, which may damage the bonding surfaces of the substrates W1 and W2.

In the conventional bonding method, if cleaning with water is performed immediately before bonding the substrates W1 and W2, there is a possibility that the bonding strength of the substrates W1 and W2 is lowered, and thus it is difficult to perform cleaning. For this reason, it has been difficult to avoid generation of voids caused by particles adhering to the bonding surfaces of the substrates W1 and W2. On the other hand, in the bonding system according to the present embodiment, after cleaning is performed in the cleaning device 3, the cleaning is input to the bonder 1. In the cleaning in the cleaning device 3, a large amount of water molecules adhere to the bonding surfaces of the substrates W1 and W2, but can be removed by performing a heat treatment process in the bonder 1. Therefore, since the cleaning process of removing particles from the bonding surfaces of the substrates W1 and W2 with water can be performed before the bonding process is performed, it is preferable also from the viewpoint of suppressing voids generated in the substrates W1 and W2 bonded to each other.

In the activation treatment process according to the present embodiment, in order to reliably irradiate the entire substrate W1 with the particle beam, the region including the portions of the cover 122A and 122B parts outside the both end edges of the substrates W1 and W2 in the moving direction of the particle beam sources 161 and 162 is irradiated with the particle beam radiated from the particle beam sources 161 and 162. In the particle beam sources 161 and 162, the strength of the particle beam at both end portions in the long direction of the long discharge chamber 1601 tends to greatly decrease. Therefore, as illustrated in FIG. 6, the lengths of the particle beam sources 161 and 162 are set to be longer than the lengths of the particle beam sources 161 and 162 in the long directions of the substrates W1 and W2. Therefore, the region including the cover 122A and 122B parts outside the both end edges of the substrates W1 and W2 in the long direction of the particle beam sources 161 and 162 is irradiated with the particle beam radiated from the particle beam sources 161 and 162. Therefore, if impurities adhere to the surfaces of the covers 122A and 122B, there is a possibility that the impurities adhering to the surfaces of the covers 122A and 122B are repelled by the particle beam irradiated to the covers 122A and 122B and adhere to the bonding surfaces of the substrates W1 and W2 when the activation treatment process is performed.

On the other hand, in the bonding method according to the present embodiment, the covers 122A and 122B are heated before the activation treatment process is performed to remove impurities adhering to the surfaces of the covers 122A and 122B. This makes it possible to suppress adhesion of impurities to the bonding surfaces of the substrates W1 and W2 due to the impurities adhering to the surfaces of the covers 122A and 122B being repelled by the particle beam during the activation treatment process.

Furthermore, in the bonding method according to the present embodiment, after the heat treatment process is performed in the load lock unit 83, the heat treatment process is further performed immediately before the activation treatment process. Due to this, after impurities mainly composed of moisture are removed to some extent in advance by the load lock unit 83, impurities mainly composed of moisture are further removed in the heat treatment process in the bonder 1, so that the time required for the heat treatment process in the bonder 1 can be shortened. Therefore, since the time required for the entire treatment performed on the substrates W1 and W2 in the bonder 1 can be shortened, the treatment efficiency can be increased accordingly.

In a case where the heat treatment process is performed only in the load lock unit 83 and the heat treatment process is not performed in the bonder 1, the bonding strength of the substrates W1 and W2 is reduced as compared with a case where the heat treatment process is performed in the bonder 1. Therefore, after the heat treatment process is performed in the load lock unit 83, it is preferable to further perform the heat treatment process also in the bonder 1. Since the substrates W1 and W2 are conveyed from the atmosphere into the load lock unit 83, impurities mainly composed of moisture adhere to the bonding surfaces of the substrates W1 and W2. Therefore, it is preferable that the load lock unit 83 is primarily subjected to the heat treatment process in a reduced-pressure atmosphere of 10-2 Pa, and then the bonder 1 is further subjected to the heat treatment process in a reduced-pressure atmosphere of 10-5 Pa. This makes it possible to substantially completely remove impurities adhering to the bonding surfaces of the substrates W1 and W2, and therefore the bonding strength of the substrates W1 and W2 can be improved. In sample 8, the heat treatment was performed for 10 minutes in the load lock unit 83, but one cycle of the bonding system according to the present embodiment is about 15 minutes. In this manner, in the bonding system according to the present embodiment, the heat treatment for 10 minutes in the load lock unit 83 can be performed without reducing the cycle time of one cycle.

Here, in order to examine the influence of moisture contained in the environment for evaluating the bonding strength of the substrates W1 and W2 on the bonding strength of the substrates W1 and W2, the results of evaluating the bonding strength of the substrates W1 and W2 formed of SiN using the above-described crack-and-opening method in the atmosphere, in a $N_2$ atmosphere, and in a vacuum ($1 \times 10^{-3}$ Pa) will be described. Here, in the $N_2$ atmosphere, moisture was contained in a smaller amount than that in the atmosphere, and in order to further reduce the amount of moisture in the environment, vacuum of $1 \times 10^{-3}$ Pa was used. In the atmosphere, the bonding strength was 1.1 J/m$^2$, whereas in the $N_2$ atmosphere, the bonding strength was 1.5 J/m$^2$, and in the vacuum, the bonding strength became 2.5 J/m$^2$ or more. This is considered to indicate that when moisture is contained in the environment for evaluating the bonding strength, the moisture is diffused to the bonding interface between the substrates W1 and W2, so that stress corrosion at the bonding interface progresses to decrease the bonding strength. This suggests that the stress corrosion in the region susceptible to the influence of the moisture existing at the bonding interface is suppressed by removing the moisture adhering to the bonding surfaces of the substrates W1 and W2 by performing the above-described heat treatment, and the bonding strength of the substrates W1 and W2 is improved. However, this shows an example of a factor of the effect of improving the bonding strength by the heat treatment described above, and the effect of improving the bonding strength is not limited to this factor.

(Second embodiment)

The bonding system according to the present embodiment is different from the first embodiment in that the substrates W1 and W2 are what is called hydrophilically bonded to each other. The bonding system according to the present embodiment performs the activation treatment process of activating the bonding surfaces of the substrates W1 and W2, and then performs the water cleaning process of cleaning the bonding surfaces of the substrates W1 and W2 with water.

The configuration of the bonding system according to the present embodiment is similar to that of the bonding system described in the first embodiment. Hereinafter, the same configurations as those of the first embodiment will be described using the same reference signs as those illustrated in FIGS. 1 to 3. Note that the gas pressure in the chamber 120 of the bonder 1 can be set within a range of 1 Pa or more and 1000 Pa or less.

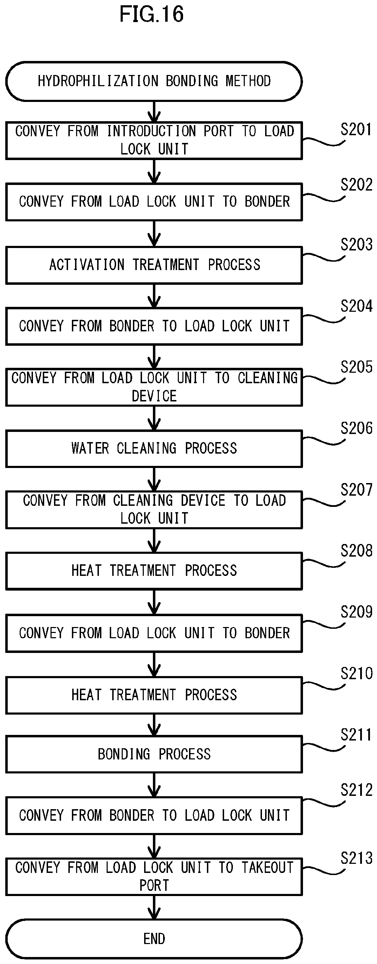

Next, a hydrophilization bonding method in which the bonding system according to the present embodiment performs what is called hydrophilic bonding of the substrates W1 and W2 will be described with reference to FIG. 16. Here, it is assumed that the substrates W1 and W2 are disposed in the introduction ports 811 and 812 illustrated in FIG. 1 in a posture where the bonding surfaces are vertically upward. Note that in the introduction port 811, the substrate W2 held by the head 142 in the bonder 1, for example, is disposed, and in the introduction port 812, the substrate W1 placed on the stage 141 in the bonder 1, for example, is disposed. First, the first conveyance device 82 takes out the substrate W2 disposed in the introduction ports 811 and 812 and conveys the substrate W2 to the load lock unit 83 (step S201). Here, the conveyance robot 821 takes out the substrates W1 and W2 from the introduction ports 811 and 812. Then, when the gate drive unit 834 of the load lock unit 83 opens the gate 833a of the standby chamber 831 on the first conveyance device 82 side, the conveyance robot 821 turns so that the tip end part of the arm 821a faces the load lock unit 83 side in a state of holding the substrates W1 and W2. At this time, when taking out the substrate W2 from the introduction port 812, the conveyance robot 821 turns in a state of holding the substrate W2 in a posture where the bonding surface of the substrate W2 faces vertically downward by reversing the arm 821a so that the bonding surface side of the substrate W2 faces vertically downward. On the other hand, when the substrate W1 is taken out from the introduction port 811, the conveyance robot 821 turns in a state where the posture of the substrate W2 is maintained in a posture where the bonding surface side faces vertically upward. Thereafter, the conveyance robot 821 extends the arm 821a to insert the tip end part of the arm 821a into the standby chamber 831. Then, the substrates W1 and W2 are transferred from the tip end part of the arm 821a to the cassette 8361 of the substrate holding mechanism 836 disposed in the standby chamber 831. Next, upon completing the transfer of the substrates W1 and W2 to the cassette 8361 of the substrate holding mechanism 836, the conveyance robot 821 contracts the arm 821a. Then, the gate drive unit 834 closes the gate 833a of the standby chamber 831.

Thereafter, the second conveyance device 84 conveys the substrates W1 and W2 held by the cassette 8361 of the substrate holding mechanism 836 from the load lock unit 83 to the bonder 1 (step S202). Note that the operation in step S202 is similar to the operation in step S105 described in the embodiment.

Next, the activation treatment process of activating the bonding surfaces of the two substrates W1 and W2 is performed in a reduced-pressure atmosphere (step S203). Note that the operation in step S203 is similar to the operation in step S107 described in the embodiment.

Subsequently, the second conveyance device 84 conveys the substrates W1 and W2 from the bonder 1 to the load lock unit 83 (step S204). Here, the second conveyance device 84 transfers, for example, the substrates W1 and W2 to the lowermost slot SLT1 and the uppermost slot SLT3 of the cassette 8361, respectively. Thereafter, the conveyance robot 821 conveys the substrates W1 and W2 to the cleaning device 3 (step S205). Here, when the gate drive unit 834 of the load lock unit 83 opens the gate 833a of the standby chamber 831 on the first conveyance device 82 side, the conveyance robot 821 takes out the substrates W1 and W2 from the cassette 8361 in the standby chamber 831. Then, when the cleaning device 3 opens the conveyance inlets of the substrates W1 and W2, the conveyance robot 821 turns so that the tip end part of the arm 821a faces the cleaning device 3 side in a state of holding the substrates W1 and W2. Next, the conveyance robot 821 extends the arm 821a and inserts the tip end part of the arm 821a into the cleaning device 3. Then, the substrates W1 and W2 are transferred from the tip end part of the arm 821a of the conveyance robot 821 to the stage of the cleaning device 3.

Subsequently, the cleaning device 3 executes the water cleaning process of cleaning the substrates W1 and W2 with water (step S206). This water cleaning process corresponds to a hydrophilization treatment process of hydrophilizing the bonding surfaces of the substrates W1 and W2. The cleaning device 3 corresponds to a hydrophilization treatment device that hydrophilizes using water. Thereafter, the first conveyance device 82 conveys the substrates W1 and W2, for which the water cleaning process has been completed, from the cleaning device 3 to the load lock unit 83 (step S207). Next, in the standby chamber 831 in a reduced-pressure atmosphere, a heat treatment process of heating the bonding surfaces to be bonded to each other of the two substrates W1 and W2 to a temperature higher than 60°C is performed (step S208). Subsequently, the second conveyance device 84 conveys the substrates W1 and W2 held by the cassette 8361 of the substrate holding mechanism 836 from the load lock unit 83 to the bonder 1 (step S209). Subsequently, the heat treatment process of heating the bonding surfaces to be bonded to each other of the two substrates W1 and W2 to a temperature higher than 60°C is performed in a reduced-pressure atmosphere (step S210). Here, since the inside of the chamber 120 is maintained in a reduced pressure within a range of 10000 Pa or less in order to reduce air entrainment voids, by performing this heat treatment process, only excessive water molecules adhering to the bonding surfaces of the substrates W1 and W2 are removed, and only a large number of OH groups contributing to bonding of the substrates W1 and W2 are present on the bonding surfaces of the substrates W1 and W2. However, in a case where the inside of the chamber 120 is evacuated from the state of being opened to the atmosphere to a decompressed state of 10000 Pa, since the inside of the chamber 120 contains a large amount of moisture, water molecules cannot be sufficiently removed by the heat treatment of the substrates W1 and W2. Therefore, the degree of vacuum in the chamber 120 is preferably made 1000 Pa or less, more preferably 1 Pa or less, and still more preferably $10^{-2}$ Pa or less. As in the present embodiment, it is preferable to provide the load lock unit 83 and introduce a gas such as nitrogen not containing moisture into the chamber 120 of the bonder 1 to reduce the pressure in the chamber 120 to 10000 Pa or less. Note that the operation in steps S207 to S210 are similar to the operation in steps S103 to S106 described in the embodiment, respectively. Thereafter, the bonding process of bonding the substrates W1 and W2 is performed (step S211).

Next, the second conveyance device 84 conveys the substrates W1 and W2 bonded to each other from the bonder 1 to the load lock unit 83 (step S212). Subsequently, the first conveyance device 84 conveys the substrates W1 and W2 bonded to each other from the load lock unit 83 to the takeout port 813 (step S213). Note that the operation in steps S212 and S213 are similar to the operation in steps S109 and S110 described in the embodiment.

In the conventional hydrophilization bonding method under a reduced pressure, generation of voids due to air entrainment between the substrates W1 and W2 in the case of performing the hydrophilization bonding method in the atmosphere cannot be suppressed. In the conventional hydrophilization bonding method, although particles that cause generation of voids can be removed in the water cleaning process, excessive water adheres to the bonding surfaces of the substrates W1 and W2, and microvoids may be formed in annealing treatment performed after the substrates W1 and W2 are bonded to each other. On the other hand, in the hydrophilization bonding method according to the present embodiment, the substrates W1 and W2 are bonded to each other with the gas pressure in the chamber 120 set to 1000 Pa or less in order to avoid entrainment of air between the substrates W1 and W2. Due to this, by the heat treatment process performed before the substrates W1 and W2 are brought into contact with each other in the chamber 120, excessive water that causes microvoids attached to the bonding surfaces of the substrates W1 and W2 can be removed. Since the OH groups formed on the bonding surfaces of the substrates W1 and W2 are in direct contact with each other at the time of bonding the substrates W1 and W2, it is possible to reduce the treatment temperature or shorten the treatment time in the process of performing the annealing treatment for removing excessive water adhering to the bonding surfaces of the substrates W1 and W2 after bonding the substrates W1 and W2. For example, the treatment temperature in the annealing treatment can be reduced from 350°C to 150°C. Therefore, the substrates W1 and W2 can be bonded to each other in a relatively low temperature state in a short time. By performing an activation treatment process for generating a sufficient amount of OH groups on the bonding surfaces of the substrates W1 and W2 before bonding the substrates W1 and W2 to each other, water and impurities interposed between the substrates W1 and W2 can be substantially eliminated, and the OH groups formed on the bonding surfaces of the substrates W1 and W2 are directly bonded to each other, and therefore an increase in bonding strength of the substrates W1 and W2 is also expected.

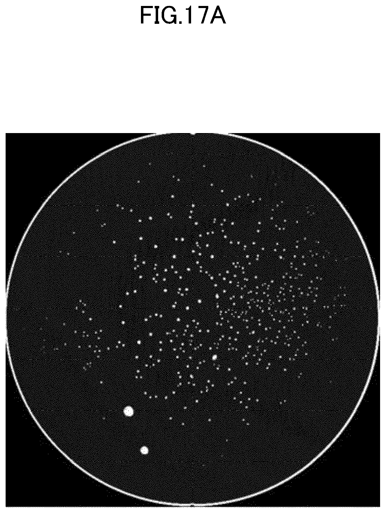

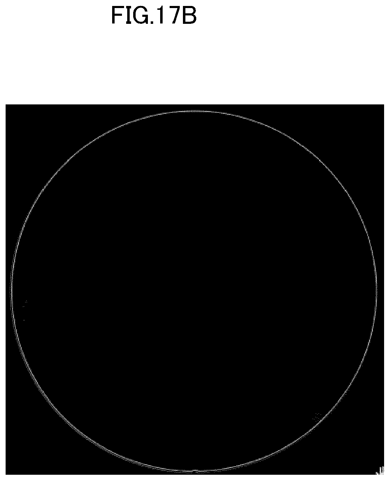

Here, in the hydrophilization bonding method according to the present embodiment, a result of comparing the appearance and the bonding strength (converted to surface energy) of the substrates W1 and W2 bonded to each other with and without performing the heat treatment process before performing the bonding process will be described. First, when the heat treatment process was not performed before the bonding process was performed, generation of microvoids was confirmed as illustrated in FIG. 17A. The bonding strength (converted to surface energy) of the substrates W1 and W2 was 1.9 mJ/m$^2$. On the other hand, when the activation treatment process was performed after the heat treatment process was performed as in the hydrophilization bonding method according to the present embodiment, the generation of microvoids was not confirmed as illustrated in FIG. 17B. The bonding strength (converted to surface energy) of the substrates W1 and W2 also became larger than 2.5 mJ/m$^2$. This indicates that by performing the heat treatment process before performing the bonding process, generation of microvoids at the bonding interface between the substrates W1 and W2 bonded to each other is suppressed, and accordingly, the bonding strength of the substrates W1 and W2 is increased.

The bonding method according to the present embodiment was also evaluated for a case where the substrates W1 and W2 formed of materials having different linear expansion coefficients were bonded to each other. Similar to the first embodiment, the above-described bonding method was performed by adopting a Si substrate as the substrate W1 and a lithium tantalate (Lt:LiTaO$_3$) substrate or a lithium niobate substrate (Ln:LiNbO$_3$) as the substrate W2. As a result, similarly to the first embodiment, when the substrates W1 and W2 were bonded to each other after the temperature of the substrates W1 and W2 decreased to a temperature lower than the temperature at the time of the heat treatment process after the heat treatment process, warpage or cracking of the substrates W1 and W2 did not occur, and the bonding strength of the substrates W1 and W2 was also improved.

When excessive moisture remains at the bonding interface between the substrates W1 and W2, stress corrosion occurs at the bonding interface due to diffusion of the moisture, and the effect of improving the bonding strength by the heat treatment may not be sustained. Therefore, it is preferable to remove moisture adhering to the bonding surfaces of the substrates W1 and W2 by performing the heat treatment process on the substrates W1 and W2 so that excessive moisture does not remain at the bonded interface of the substrates W1 and W2. The same applies to the hydrophilic bonding, and good results were obtained by removing excessive moisture by heat treatment before bonding. For example, after the hydrophilization treatment process, at least one of the bonding surfaces to be bonded to each other of the two bonded objects is heated to a temperature higher than 60°C in a reduced-pressure atmosphere, and then the two bonded objects may be bonded in a state of maintaining the reduced-pressure atmosphere.

When the substrates W1 and W2 are bonded to each other in the atmosphere, air or excessive water is entrained between the bonding surfaces of the substrates W1 and W2, which causes generation of voids. On the other hand, according to the hydrophilization bonding method according to the present embodiment, since the substrates W1 and W2 are bonded to each other in a reduced-pressure atmosphere containing less air or moisture, generation of voids as described above is suppressed. According to the hydrophilization bonding method according to the present embodiment, before the bonding process is performed, the heat treatment process of heating the bonding surfaces to be bonded to each other of the two substrates W1 and W2 to a temperature higher than 60°C in a reduced-pressure atmosphere is performed. This makes it possible to remove excessive water molecules adhering to the bonding surfaces of the substrates W1 and W2 and to bring into a state where only a large amount of OH groups contributing to bonding of the substrates W1 and W2 are present on the bonding surfaces of the substrates W1 and W2. Therefore, the substrates W1 and W2 can be firmly bonded to each other.

Furthermore, according to the hydrophilization bonding method according to the present embodiment, the substrates W1 and W2 are hydrophilically bonded to each other using the bonding system including the load lock unit 83. Therefore, it is no longer necessary to open the chamber 120 of the bonder 1 to the atmosphere, and therefore the treatment time can be shortened accordingly.

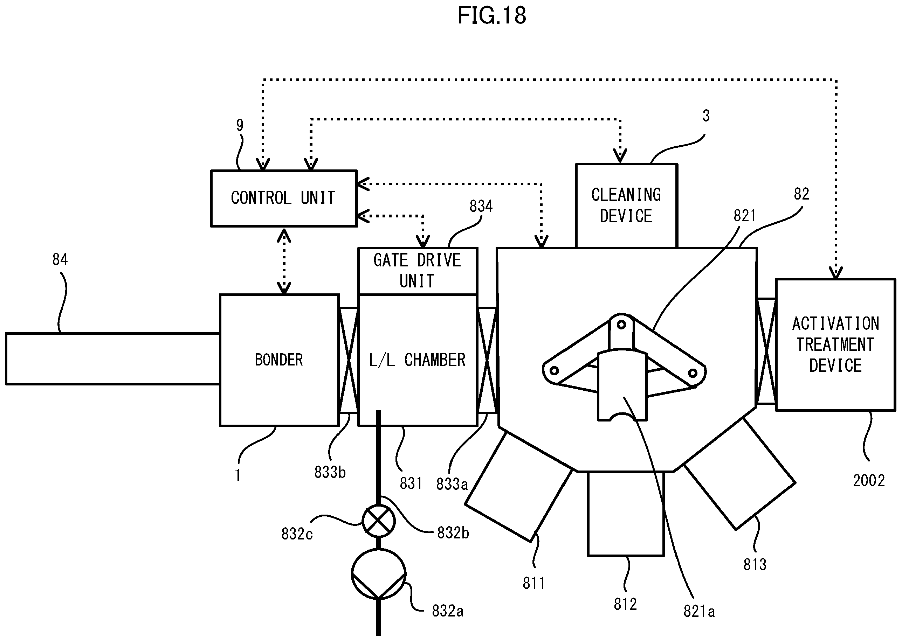

Although each embodiment of the present invention has been described above, the present invention is not limited to the configuration of each embodiment described above. For example, as illustrated in FIG. 18, the bonding system may include the introduction ports 811 and 812, the takeout port 813, the first conveyance device 82, the cleaning device 3, the bonder 1, the load lock unit 83, the second conveyance device 84, an activation treatment device 2002, and the control unit 9. In FIG. 18, the same components as those in the embodiment are denoted by the same reference signs as those in FIG. 1.

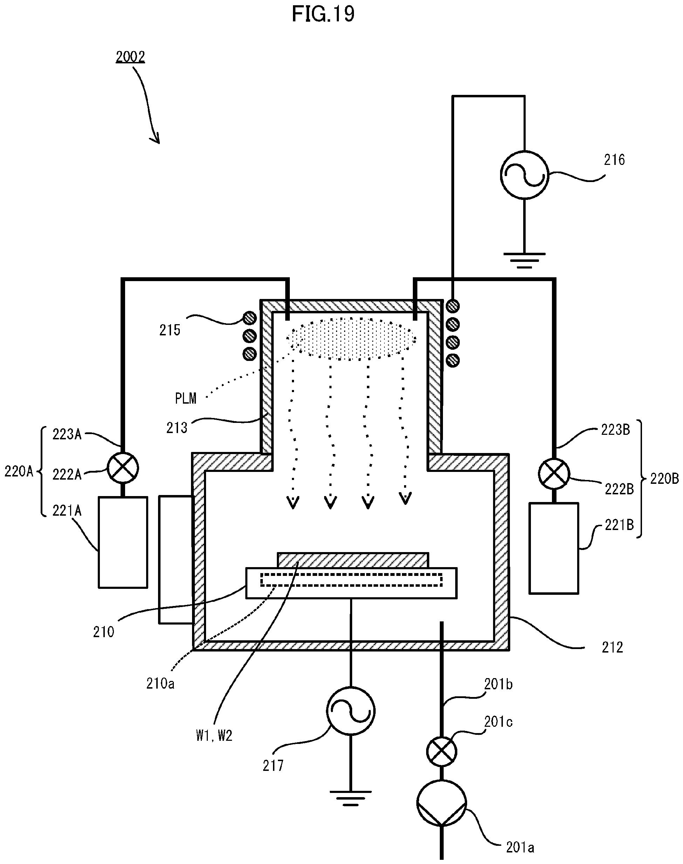

The activation treatment device 2002 performs activation treatment of activating the bonding surfaces of the substrates W1 and W2 by performing at least one of reactive ion etching using nitrogen gas and irradiation with nitrogen radicals on the bonding surfaces. Activation treatment for activating the bonding surface of the substrate is performed. The activation treatment device 2002 is a device that generates inductively coupled plasma (ICP), and includes a stage 210, a chamber 212, a plasma chamber 213, an induction coil 215 wound outside the plasma chamber 213, and a high-frequency power source 216 that supplies a high-frequency current to the induction coil 215 as illustrated in FIG. 19. Note that the activation treatment device 2 may be, for example, of a type in which plasma is generated in the upper portion of the chamber and only radicals contained in the plasma are downflowed through holes formed in an ion trap plate. The plasma generation source may be a plasma generation source of a parallel plate type or a plasma generation source using microwaves. The plasma chamber 213 is formed of, for example, quartz glass. The activation treatment device 2002 includes a nitrogen gas supply unit 220A and an oxygen gas supply unit 220B. The nitrogen gas supply unit 220A includes a nitrogen gas storage unit 221A, a supply valve 222A, and a supply pipe 223A. The oxygen gas supply unit 220B includes an oxygen gas storage unit 221B, a supply valve 222B, and a supply pipe 223B. The substrates W1 and W2 are placed on the stage 210. The stage 210 is provided with a substrate heating unit 210a that heats the substrates W1 and W2. The chamber 212 communicates with inside the plasma chamber 213. The chamber 212 is connected to a vacuum pump 201a via an exhaust pipe 201b and an exhaust valve 201c. When the exhaust valve 201c is opened and the vacuum pump 201a is operated, the gas in the chamber 212 is discharged to the outside of the chamber 212 through the exhaust pipe 201b, and the gas pressure in the chamber 212 is reduced (decompressed). The gas pressure in the chamber 212 can be $10^{-2}$ Pa or less.

As the high-frequency power source 216, one that supplies a high-frequency current of, for example, 27 MHz to the induction coil 215 can be adopted. Then, when a high-frequency current is supplied to the induction coil 215 in a state where the N2 gas is introduced into the plasma chamber 213, plasma PLM is formed in the plasma chamber 213. Here, since ions contained in the plasma are trapped in the plasma chamber 213 by the induction coil 215, there may be no trap plate in a part between the plasma chamber 213 and the chamber 212. A bias application unit 217 is a high-frequency power source that applies a high-frequency bias to the substrates W1 and W2 supported by the stage 210. As this bias application unit 217, for example, one that generates a high-frequency bias of 13.56 MHz can be adopted. In this manner, by applying the high-frequency bias to the substrates W1 and W2 by the bias application unit 217, a sheath region is generated in which ions having kinetic energy repeatedly collide with the substrates W1 and W2 in the vicinity of the bonding surfaces of the substrates W1 and W2. Then, the bonding surfaces of the substrates W1 and W2 are etched by ions having kinetic energy existing in this sheath region.

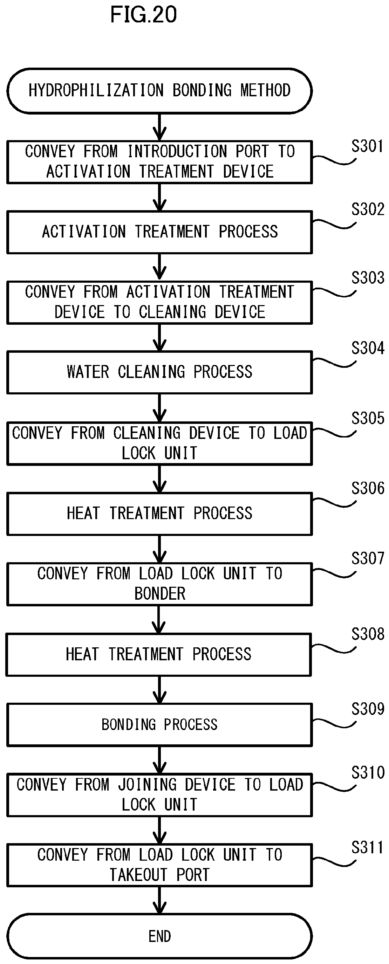

Here, the hydrophilization bonding method in which the bonding system according to the present modification performs what is called hydrophilic bonding of the substrates W1 and W2 will be described with reference to FIG. 20. Here, it is assumed that the substrates W1 and W2 are disposed in the introduction ports 811 and 812 illustrated in FIG. 1 in a posture where the bonding surfaces are vertically upward. Note that in the introduction port 811, the substrate W2 held by the head 142 in the bonder 1, for example, is disposed, and in the introduction port 812, the substrate W1 placed on the stage 141 in the bonder 1, for example, is disposed.

First, the first conveyance device 82 takes out the substrate W2 disposed in the introduction ports 811 and 812 and conveys the substrate W2 to the activation treatment device 2002 (step S301). Here, the conveyance robot 821 takes out the substrates W1 and W2 from the introduction ports 811 and 812. Then, when the introduction port of the activation treatment device 2002 is opened, the conveyance robot 821 turns so that the tip end part of the arm 821a faces the activation treatment device 2002 in a state of holding the substrates W1 and W2. At this time, the conveyance robot 821 turns in a state where the substrates W1 and W2 taken out from the introduction ports 811 and 812 are maintained in a posture where the bonding surface side faces vertically upward. Thereafter, the conveyance robot 821 extends the arm 821a to insert the tip end part of the arm 821a into the chamber 212. Then, the substrates W1 and W2 are transferred from the tip end part of the arm 821a to the stage 210 in the chamber 212. Next, upon completing the transfer of the substrates W1 and W2 to the stage 210, the conveyance robot 821 contracts the arm 821a.

Next, after decompressing the inside of the chamber 212 of the activation treatment device 2002, the substrate heating unit 210a heats the substrates W1 and W2 in a state where the substrates W1 and W2 are placed on the stage 210. Subsequently, the activation treatment process of activating the bonding surfaces of the substrates W1 and W2 is performed in a reduced-pressure atmosphere (step S302). Here, the reduced-pressure atmosphere is, for example, a state where the gas pressure in the chamber 212 is $1 \times 10^{-2}$ Pa or less. The activation treatment device 2002 introduces the N2 gas into the chamber 212 from the nitrogen gas storage unit 221A through the supply pipe 223A by opening the supply valve 222A illustrated in FIG. 16, for example. Next, the activation treatment device 2002 applies a high-frequency bias to the substrates W1 and W2 placed on the stage 210 by the bias application unit 217 in a state where the supply of the high-frequency current from the high-frequency power source 216 to the induction coil 215 is stopped. Due to this, reactive ion etching (RIE) using N2 gas is performed on the bonding surface of the substrate W1. Subsequently, the activation treatment device 2002 starts supplying a high-frequency current from the high-frequency power source 216 to the induction coil 215, and generates plasma with N2 gas. At this time, the activation treatment device 2002 stops the application of the high-frequency bias to the substrate W1 by the bias application unit 217. In this manner, the bonding surface of the substrate W1 is irradiated with N2 radicals.

On the other hand, when performing activation treatment on the substrate W2, that is, the bonding surface of the Si or nitride substrate, the activation treatment device 2002 first introduces the O2 gas into the chamber 212 from the oxygen gas storage unit 221B through the supply pipe 223B by opening the supply valve 222B. Next, the activation treatment device 2002 applies a high-frequency bias to the substrate W2 placed on the stage 210 by the bias application unit 217 in a state where the supply of the high-frequency current from the high-frequency power source 216 to the induction coil 215 is stopped. Due to this, reactive ion etching (RIE) using O2 gas is performed on the bonding surface of the substrate W2. Subsequently, the activation treatment device 2002 exhausts the O2 gas in the chamber 612 by closing the supply valve 622B and stopping the supply of the O2 gas from the O2 gas storage unit 621B into the chamber 612. Thereafter, the activation treatment device 2002 introduces the N2 gas into the chamber 212 from the nitrogen gas storage unit 221A through the supply pipe 223A by opening the supply valve 222A. Thereafter, the activation treatment device 2002 starts supplying a high-frequency current from the high-frequency power source 216 to the induction coil 215, and generates plasma with N2 gas. At this time, the activation treatment device 2002 stops the application of the high-frequency bias to the substrate W2 by the bias application unit 217. In this manner, the bonding surface of the substrate W2 is irradiated with N2 radicals. Note that the cover heating process of heating a cover (not illustrated) disposed in the chamber 212 so as to include the activation treatment region around the substrates W1 and W2 to be subjected to the activation treatment may be performed simultaneously with the activation treatment process or before the activation treatment process.

Thereafter, the conveyance robot 821 conveys the substrates W1 and W2 to the cleaning device 3 (step S303). Here, when the introduction port of the activation treatment device 2002 is opened, the conveyance robot 821 takes out the substrates W1 and W2 placed on the stage 210 in the chamber 212 of the activation treatment device 2002. Then, when the cleaning device 3 opens the conveyance inlets of the substrates W1 and W2, the conveyance robot 821 turns so that the tip end part of the arm 821a faces the cleaning device 3 side in a state of holding the substrates W1 and W2. Next, the conveyance robot 821 extends the arm 821a and inserts the tip end part of the arm 821a into the cleaning device 3. Then, the substrates W1 and W2 are transferred from the tip end part of the arm 821a of the conveyance robot 821 to the stage of the cleaning device 3.

Subsequently, the cleaning device 3 executes the water cleaning process of cleaning the substrates W1 and W2 with water (step S304). Thereafter, the first conveyance device 82 conveys the substrates W1 and W2, for which the water cleaning process has been completed, from the cleaning device 3 to the load lock unit 83 (step S305). Here, when receiving the substrate W2 from the cleaning device 3, the conveyance robot 821 turns in a state of holding the substrate W2 in a posture where the bonding surface of the substrate W2 faces vertically downward by reversing the arm 821a so that the bonding surface side of the substrate W2 faces vertically downward, and then conveys the substrate W2 to the load lock unit 83. Next, in the standby chamber 831 in a reduced-pressure atmosphere, a heat treatment process of heating the bonding surfaces to be bonded to each other of the two substrates W1 and W2 to a temperature higher than 60°C is performed (step S306). Subsequently, the second conveyance device 84 conveys the substrates W1 and W2 held by the cassette 8361 of the substrate holding mechanism 836 from the load lock unit 83 to the bonder 1 (step S307). Thereafter, the heat treatment process of heating the bonding surfaces to be bonded to each other of the two substrates W1 and W2 to a temperature higher than 60°C is performed in a reduced-pressure atmosphere (step S308). Next, the bonding process of bonding the substrates W1 and W2 is performed (step S309).

Thereafter, the second conveyance device 84 conveys the substrates W1 and W2 bonded to each other from the bonder 1 to the load lock unit 83 (step S310). Next, the first conveyance device 84 conveys the substrates W1 and W2 bonded to each other from the load lock unit 83 to the takeout port 813 (step S311). Note that the operation in steps S310 and S311 are similar to the operation in steps S109 and S 110 described in the embodiment.

According to the present configuration, since the number of processes can be reduced in the case of what is called hydrophilically bonding of the substrates W1 and W2, the time required for bonding of the substrates W1 and W2 can be shortened.

In the embodiment, an example in which, after the activation treatment process is performed, in the bonding process, the head drive unit 144 executes the alignment operation of the both substrates W1 and W2 based on the positional displacement amount measured by the positional displacement amount measurement unit 150 in a state where the substrates W1 and W2 are close to each other has been described. However, the present invention is not limited to this, and for example, the head drive unit 144 may execute the alignment operation of the substrates W1 and W2 before performing the activation treatment process. In this case, since the bonding process can be performed immediately after the activation treatment process, the substrates W1 and W2 can be bonded to each other in a state where their bonding surfaces are activated.

In the embodiment, an example in which the covers 122A and 122B are disposed around the stage 141 and the head 142 in the chamber 120 has been described, but the present invention is not limited to this, and for example, the covers 122A and 122B may be disposed only around the cover 122A or the head 142 in the chamber 120.

In the bonding method illustrated in FIG. 8 according to the embodiment, the heat treatment process in step S 104 or the heat treatment process in step S 106 may be omitted. In step S 104, the heat treatment is performed in a reduced-pressure atmosphere of about $10^{-2}$ Pa, whereas in the heat treatment performed in step S 106, the heat treatment is performed in a reduced-pressure atmosphere of about $10^{-6}$ Pa. Here, as illustrated in FIG. 15, since the bonding strength of the substrates W1 and W2 greatly increases in a reduced-pressure atmosphere of $10^{-6}$ Pa, from the viewpoint of firmly bonding the substrates W1 and W2 to each other, it is preferable to omit the heat treatment process in step S104 rather than omit the heat treatment process in step S106.

In the modification of the hydrophilization bonding method described above with reference to FIGS. 16 to 20, the load lock unit 83 may be omitted. In the modification of the hydrophilization bonding method described above, since the gas pressure in the chamber 120 of the bonder 1 may be set within the range of 1 Pa or more and 1000 Pa or less, even if the method of conveying the substrates W1 and W2 into the chamber 120 in a state where the chamber 120 is opened to the atmosphere is adopted, the treatment time does not become extremely long. Therefore, in the modification of the hydrophilization bonding method described above, the load lock unit 83 can be omitted.

In the second embodiment, an example in which the substrates W1 and W2 are bonded to each other after the water cleaning process of performing water cleaning is performed after the activation treatment process has been described, but the present invention is not limited to this. For example, in the activation treatment process, the substrates W1 and W2 may be bonded to each other after OH groups are generated on the bonding surfaces of the substrates W1 and W2 by chemically treating the bonding surfaces of the substrates W1 and W2 using wet treatment. Alternatively, after only the water cleaning process is performed without the activation treatment process, the substrates W1 and W2 may be bonded to each other.

In each embodiment, the method of heat treatment on the covers 122A and 122B may be performed simultaneously when the chamber 120 is baked, or may be performed simultaneously when the heat treatment process of the substrates W1 and W2 performed before the activation treatment process is performed.

In each embodiment, an example in which the bonding surfaces of the substrates W1 and W2 are irradiated with the particle beam in the activation treatment process has been described, but the present invention is not limited to this, and for example, the bonding surfaces of the substrates W1 and W2 may be irradiated with an ion beam using an ion gun. In each embodiment, the particle beam sources 161 and 162 may irradiate the bonding surfaces of the substrates W1 and W2 with Si particles together with argon. Furthermore, in the first embodiment, a plasma generation source may be adopted instead of the particle beam sources 161 and 162.

In each embodiment, the heat treatment process may be performed only in the bonder 1 without performing the heat treatment process in the load lock unit 83.

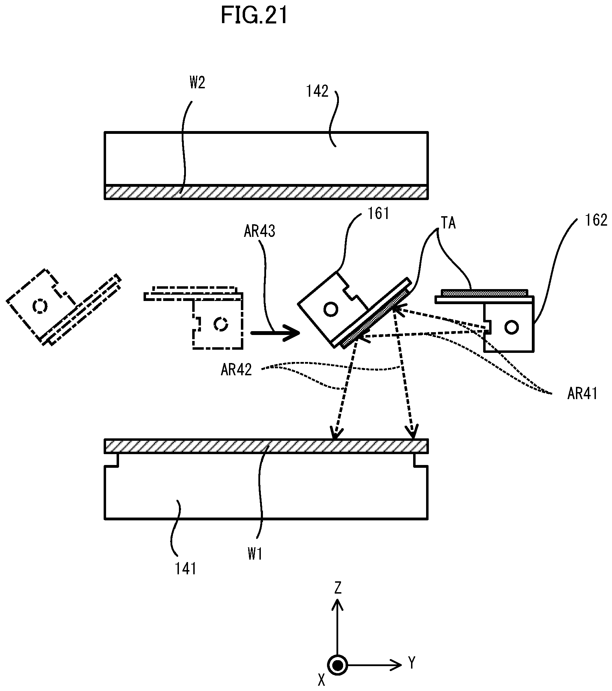

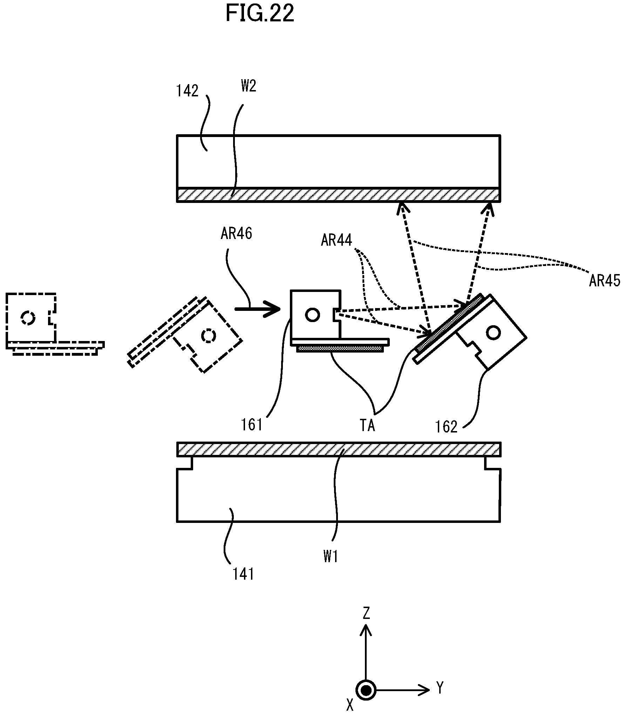

In each embodiment, a Si particle deposition process of depositing Si particles on at least one bonding surface of the two substrates W1 and W2 may be performed. In this case, for example, the bonding surfaces of the substrates W1 and W2 may be irradiated with Si particles using the two particle beam sources 161 and 162. In this case, for example, as illustrated in FIG. 21, a target material TA formed of Si is fixed to a side surface of the particle beam source 161, and the particle beam source 162 irradiates the target material TA fixed to the particle beam source 161 with the particle beam as indicated by arrow AR41, thereby sputtering the target material TA. At this time, the target material TA fixed to the particle beam source 161 is sputtered by the particle beam incident from the particle beam source 162, and Si particles are irradiated from the target material TA to the bonding surface of the substrate W1 as indicated by arrow AR42. Here, the two particle beam sources 161 and 162 to which the target material TA is fixed correspond to the Si particle irradiation unit. Then, by moving the two particle beam sources 161 and 162 as indicated by arrow AR43, a Si layer is formed on the bonding surface of the substrate W1. For example, as illustrated in FIG. 22, the target material TA formed of Si is fixed to a side surface of the particle beam source 162, and the particle beam source 161 irradiates the target material TA fixed to the particle beam source 162 with the particle beam as indicated by arrow AR44, thereby sputtering the target material TA. At this time, the target material TA fixed to the particle beam source 162 is sputtered by the particle beam incident from the particle beam source 161, and Si particles are irradiated from the target material TA to the bonding surface of the substrate W2 as indicated by arrow AR45. Then, by moving the two particle beam sources 161 and 162 as indicated by arrow AR44, a Si layer is formed on the bonding surface of the substrate W2. After the Si layer is formed on the substrates W1 and W2, the Si layer may be etched by irradiating the Si layer with a particle beam.

In a case where the substrates W1 and W2 are formed of SiO2, when the substrates W1 and W2 are bonded to each other after the Si layer is formed on the bonding surfaces of the substrates W1 and W2, the bonding strength of the substrates W1 and W2 is further improved. When the formation of the Si layer by depositing the Si particles on the substrates W1 and W2 and the etching of the Si layer by irradiating the Si layer with the particle beam containing Ar are simultaneously performed, it is difficult to adjust the balance between the deposition amount of the Si particles and the etching amount of the Si layer. On the other hand, in the method in which after the Si layer is formed on the substrates W1 and W2, the Si layer may be etched by irradiating the Si layer with a particle beam, if the sputtering time of the target TA by the particle beam source 161 and the time of irradiating the substrates W1 and W2 with the particle beam are controlled to appropriately adjust the balance between the thickness of the Si layer formed by sputtering and the etching amount by the particle beam as described above, it is possible to form a Si layer having an optimum thickness or an island-like region formed of Si. For example, even in a structure in which electrodes are exposed on the substrates W1 and W2, by forming a Si layer having an optimum thickness or an island-like region formed of Si, the electrodes do not electrically conduct to each other, and the bonding strength of the substrates W1 and W2 can be increased.

As described in the first embodiment with reference to FIG. 15, in a case where the substrates W1 and W2 are Si substrates, impurities mainly composed of moisture floating in the chamber 120 are removed by increasing the degree of vacuum, so that the strength is rapidly improved. Based on this result, in the present modification, particularly when the substrates W1 and W2 are formed of a material other than Si, the bonding strength of the substrates W1 and W2 bonded by the bonding method of performing the heat treatment process on the substrates W1 and W2 can be improved by irradiating the bonding surfaces of the substrates W1 and W2 with Si particles to form the Si layer.

Here, regarding the case where the substrates W1 and W2 are formed of $SiO_2$, the results of comparing the bonding strength when the substrates W1 and W2 are bonded to each other between the case where the Si layer is formed on the bonding surfaces of the substrates W1 and W2 and the case where the Si layer is not present will be described. Here, four samples 11 to 14 were prepared, and their bonding strength was evaluated. Note that samples 11 to 14 were prepared under the condition that the bonding strength was lowered than the condition described in the embodiment, for easily confirming the temporal change in the bonding strength of the substrates W1 and W2. Sample 11 was prepared by scanning the two particle beam sources 161 and 162 set in the posture illustrated in FIG. 22 on the substrates W1 and W2 a plurality of times to form a Si layer on the bonding surfaces of the substrates W1 and W2, respectively, and then scanning the substrates W1 and W2 once with the particle beam sources 161 and 162 in the posture of irradiating the substrates W1 and W2 with the particle beam. Sample 12 was subjected to similar treatment to that of sample 11, and then subjected to heat treatment in which the substrates W1 and W2 were maintained at 150°C for 10 minutes. Sample 13 was prepared by scanning the two particle beam sources 161 and 162 set in the posture illustrated in FIG. 22 on the substrates W1 and W2 a plurality of times to form a Si layer on the bonding surfaces of the substrates W1 and W2, and then scanning the substrates W1 and W2 a plurality of times with the particle beam sources 161 and 162 in the posture of irradiating the substrates W1 and W2 with the particle beam. Sample 14 was subjected to similar treatment to that of sample 13, and then subjected to heat treatment in which the substrates W1 and W2 were maintained at 150°C for 10 minutes. Here, the Si layers of samples 11 and 12 are thinner than the Si layers of samples 13 and 14. Specifically, the Si layer of samples 11 and 12 is less than 3 nm, and the Si layer of samples 13 and 14 is 3 nm or more.

For samples 11 to 14, the bonding strength immediately after bonding of the substrates W1 and W2 and the bonding strength 1 week to 4 weeks after bonding of the substrates W1 and W2 were evaluated using the crack-and-opening method described in the first embodiment. As a result, immediately after bonding of the substrates W1 and W2, the bonding strength (0.48 mJ/m$^2$) of sample 12 was larger than the bonding strength (0.25 mJ/m2) of sample 11, and the bonding strength (1.1 mJ/m$^2$) of sample 14 was larger than the bonding strength (0.7 mJ/m$^2$) of sample 13. However, after a lapse of 1 week to 4 weeks after bonding of the substrates W1 and W2, the bonding strength of samples 11 and 12 is approximately 0.5 mJ/m$^2$, which is substantially equal. On the other hand, the bonding strength (1.49 mJ/m$^2$) of sample 14 was larger than the bonding strength (1.15 mJ/m$^2$) of sample 13. This suggests that when the Si layer is relatively thin, the effect of improving the bonding strength of the substrates W1 and W2 by the heat treatment is not sustained, and when the Si layer is thick to some extent, the effect of improving the bonding strength of the substrates W1 and W2 by the heat treatment is sustained. This is because in the case of samples 11 and 12, since the Si layer is relatively thin, moisture remaining at the bonding interface between the substrates W1 and W2 makes it easy to form a SiOz region at the bonding interface between the substrates W1 and W2. Then, it is considered that the moisture remaining at the bonding interface between the substrates W1 and W2 diffuses over time via the above-described $SiO_2$

region, so that the stress corrosion at the bonding interface progresses, and the effect of improving the bonding strength of the substrates W1 and W2 by the heat treatment is offset by the decrease in the bonding strength due to the stress corrosion. On the other hand, in the case of samples 13 and 14, since the Si layer is relatively thick, the bond of Si-Si is dominant at the bonding interface between the substrates W1 and W2, and therefore the SiOz region is hardly formed at the bonding interface between the substrates W1 and W2. For this reason, it is considered that diffusion of moisture remaining at the bonding interface between the substrates W1 and W2 is suppressed, stress corrosion at the bonding interface due to this is suppressed, and as a result, the effect of improving the bonding strength of the substrates W1 and W2 by the heat treatment is sustained. In other words, when the $SiO_2$ region is dominant at the bonding interface between the substrates W1 and W2, stress corrosion occurs at the bonding interface due to diffusion of moisture remaining at the bonding interface between the substrates W1 and W2, and the effect of improving the bonding strength by the heat treatment is not sustained. Similar results were obtained when the substrates W1 and W2 were formed of SiN. This concludes that also when SiN is dominant at the bonding interface between the substrates W1 and W2, stress corrosion occurs at the bonding interface due to diffusion of moisture remaining at the bonding interface between the substrates W1 and W2, and the effect of improving the bonding strength by heat treatment is not sustained. That is, in the hydrophilic bonding, when a region that is easily affected by moisture, such as an oxide such as the $SiO_2$ region or a nitride, is dominant at the bonding interface, stress corrosion over time due to diffusion of moisture remaining at the bonding interface occurs, and the strength of bonding between the substrates W1 and W2 decreases. On the other hand, the principle that the stress corrosion in the region susceptible to the influence of the moisture existing at the bonding interface is suppressed by reducing the moisture remaining at the bonding interface between the substrates W1 and W2 by performing the heat treatment described above, and the bonding strength of the substrates W1 and W2 is improved can be derived from the evaluation results of samples 11 to 14 described above. However, this evaluation result shows an example of a factor of the effect of improving the bonding strength by the heat treatment described above, and the effect of improving the bonding strength is not limited to this factor.

Regarding a case where the substrates W1 and W2 are sapphire substrates, a result of comparing the bonding strength when the substrates W1 and W2 are bonded to each other in a case where the bonding surfaces of the substrates W1 and W2 are irradiated with a particle beam containing carbon, and in a case where the bonding surfaces of the substrates W1 and W2 are irradiated with a particle beam containing Si particles will be described. Here, four samples 15 to 18 were prepared, and their bonding strength was evaluated. Note that samples 15 to 18 were prepared under the condition that the bonding strength was lowered than the condition described in the embodiment, for easily confirming the temporal change in the bonding strength of the substrates W1 and W2. Sample 15 was prepared by performing an activation treatment process of irradiating the substrates W1 and W2 with a particle beam containing carbon from the particle beam sources 161 and 162. Sample 16 was subjected to similar treatment to that of sample 15, and then subjected to heat treatment in which the substrates W1 and W2 were maintained at 110°C for 10 minutes. Sample 17 was prepared by performing an activation treatment process of irradiating the substrates W1 and W2 with a particle beam containing Si particles from the particle beam sources 161 and 162. Sample 18 was subjected to similar treatment to that of sample 17, and then subjected to heat treatment in which the substrates W1 and W2 were maintained at 110°C for 10 minutes.

For samples 15 to 18, the bonding strength immediately after bonding of the substrates W1 and W2 and the bonding strength 1 week to 4 weeks after bonding of the substrates W1 and W2 were evaluated using the above-described crack-and-opening method. As a result, immediately after bonding of the substrates W1 and W2, the bonding strength ($2.4$ mJ/m$^2$) of sample 16 was larger than the bonding strength ($2.0$ mJ/m$^2$) of sample 15, and the bonding strength of sample 18 was $1.8$ mJ/m$^2$. However, after a lapse of 1 week to 4 weeks after bonding of the substrates W1 and W2, the bonding strength of samples 15 and 16 decreased to $0.9$ mJ/m$^2$ and became substantially equal. The bonding strength of samples 17 and 18 also decreased to $0.6$ to $0.7$ mJ/m$^2$, and became substantially equal. This suggests that when the substrates W1 and W2 are sapphire substrates, the influence of moisture remaining at the bonding interface between the substrates W1 and W2 on the bonding strength is small.

From the above results, the bonding method including the Si particle deposition process according to the present modification is effective when the substrates W1 and W2 are formed of $SiO_2$.

In the present modification, the method of irradiating the bonding surfaces of the substrates W1 and W2 with Si particles is not limited to the above-described method of irradiating the Si particles, and for example, a film forming device different from the bonder 1 may irradiate the bonding surfaces of the substrates W1 and W2 with Si particles. In this manner, forming the Si layer on the bonding surfaces of the substrates W1 and W2 by irradiating the bonding surfaces of the substrates W1 and W2 with the Si particles is effective because the strength is enhanced by generation of the OH group in the driven Si not only in the case of what is called direct bonding of the substrates W1 and W2 as described in the first embodiment but also in the case of hydrophilic bonding of the substrates W1 and W2 as described in the second embodiment.

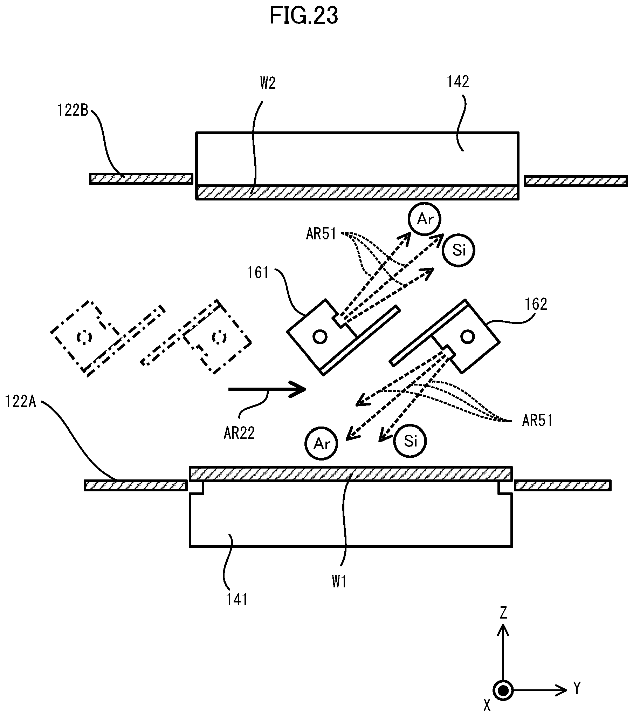

Apart from the modification described with reference to FIGS. 21 and 22, for example, in the activation treatment process of the first embodiment, at least one of the bonding surfaces of the substrates W1 and W2 may be irradiated with Si particles together with a particle beam as indicated by arrow AR51 in FIG. 23. Here, for example, if some or all of the inner walls of the discharge chamber 1601 of the particle beam sources 161 and 162 described with reference to FIG. 5 are formed of Si, Si particles can be emitted from the particle beam sources 161 and 162 simultaneously with the Ar beam. In this manner, by irradiating the bonding surfaces of the substrates W1 and W2 with Si particles simultaneously with irradiation with the particle beam, the Si particles are driven into the bonding surfaces of the substrates W1 and W2. Since the Si particles driven into the bonding surfaces of the substrates W1 and W2 are etched by the particle beam containing Ar or $N_2$, the Si particles are not deposited to form a Si layer, and the bonding surface can be modified to a Si-rich surface.

As described in the first embodiment with reference to FIG. 15, in a case where the bonding surfaces of the substrates W1 and W2 is Si, impurities mainly composed of moisture floating in the chamber 120 are removed by increasing the degree of vacuum, so that the strength is rapidly improved. Based on this result, in the present modification, particularly when the substrates W1 and W2 are formed of a material other than Si, Si particles are driven into the bonding surfaces of the substrates W1 and W2, thereby improving the bonding strength of the substrates W1 and W2 bonded by a bonding method of performing the heat treatment process on the substrates W1 and W2.

In the present modification, the heat treatment process is preferably performed after Si particles are driven into the bonding surfaces of the substrates W1 and W2. Furthermore, it is preferable that after the heat treatment process is performed on the substrates W1 and W2, the activation treatment process is performed while Si particles are driven into the bonding surfaces of the substrates W1 and W2 in a state where the temperature of the substrates W1 and W2 is maintained at a temperature in the vicinity of the treatment temperature in the heat treatment process without cooling the temperatures of the substrates W1 and W2 to 60°C, and then the substrates W1 and W2 are brought into contact with each other at a temperature in the vicinity of the treatment temperature in the heat treatment process. Due to this, impurities mainly composed of moisture adhering to the bonding surfaces of the substrates W1 and W2 can be removed from the bonding surfaces of the substrates W1 and W2, and therefore the bonding strength of the substrates W1 and W2 can be improved. For example, in a case where the substrates W1 and W2 are a lithium tantalate (Lt:LiTaO$_3$) substrate and a Si substrate, respectively, when the substrates W1 and W2 are bonded without performing a process of driving Si particles into the bonding surfaces of the substrates W1 and W2, the bonding strength of the substrates W1 and W2 was 1,6 mJ/m$^2$. On the other hand, as in the present modification, when the substrates W1 and W2 were bonded to each other after the treatment of driving Si particles into the bonding surfaces of the substrates W1 and W2 was performed, the bonding strength of the substrates W1 and W2 was 2.5 J/m$^2$ or more (14.3 J/m$^2$), and there were four bulk fracture positions. That is, the bonding strength of the substrates W1 and W2 was improved. When the heat treatment process of the substrates W1 and W2 was not performed, the bonding strength of the substrates W1 and W2 was 1.3 J/m$^2$. These facts indicate that the bonding strength of the substrates W1 and W2 is improved from 1 J/m$^2$ to 1.3 J/m$^2$ by driving Si particles into the bonding surfaces of the substrates W1 and W2 in the activation treatment process as in the present modification, and the bonding strength is improved to 14.3 J/m$^2$ by performing the heat treatment process on the substrates W1 and W2. That is, it is found that the bonding strength of the substrates W1 and W2 is improved only about 0.3 J/m$^2$ only by driving Si particles into the bonding surfaces of the substrates W1 and W2, but the bonding strength of the substrates W1 and W2 is greatly improved to 13.3 J/m$^2$ by performing the heat treatment process on the substrates W1 and W2.

Furthermore, in the present modification, when Si particles are driven into the bonding surfaces of the substrates W1 and W2 in the activation treatment process, a Si layer is not formed on the bonding surfaces of the substrates W1 and W2. For this reason, even in a case where an electrode and an insulating layer are mixed on the bonding surfaces of the substrates W1 and W2, there is an advantage that the electrodes are not electrically short-circuited with each other.

An insulating film made of an oxide film, a nitride film, or the like is ionic crystalline, and cannot be bonded by what is called direct bonding in which an activation treatment process using a particle beam is performed, and bonding strength of the substrates W1 and W2 cannot be obtained only by driving Si particles into the bonding surfaces of the substrates W1 and W2. On the other hand, in the present modification, by driving Si particles into the bonding surfaces of the substrates W1 and W2 and performing the heat treatment process on the substrates W1 and W2, insulating films made of an oxide film, a nitride film, or the like can be bonded together. Therefore, for example, oxide films made of lithium tantalate (Lt:LiTaOs), a lithium niobate substrate (Ln:LiNbO$_3$), and the like used for a SAW filter can be firmly bonded to each other, and thus the performance of the SAW filter can be improved. What is called hybrid bonding in which bonding surfaces on which a metal electrode formed of Cu, Au, or the like and an insulating film made of an oxide film, a nitride film, or the like are mixed on substantially the same plane are bonded to each other successfully achieved without causing a short circuit between the metal electrodes.

Note that the method of driving Si particles into the bonding surfaces of the substrates W1 and W2 in the activation treatment process as in the present modification can improve the bonding strength of the substrates W1 and W2 not only in the case of what is called direct bonding between the substrates W1 and W2 described in the first embodiment but also in the case of hydrophilic bonding using the substrates W1 and W2 in which Si particles are driven into the bonding surfaces by this method. In this case, by subjecting the bonding surfaces of the substrates W1 and W2 to hydrophilization treatment, OH groups adhere to the Si particles driven into the bonding surfaces of the substrates W1 and W2, whereby the amount of OH groups present on the bonding surfaces of the substrates W1 and W2 increases. This improves the bonding strength of the substrates W1 and W2.

The bonding system may include, for example, an ion implantation device that performs ion implantation into any one of two bonded objects, a first heat treatment device that heats a bonding surface of each of the two bonded objects to be bonded to each other in a reduced-pressure atmosphere, an activation treatment device that activates at least one bonding surface of the two bonded objects, a bonder, and a control unit that controls operation of each of the first heat treatment device, the drive unit, and the second heat treatment device. Here, at least one of the two bonded objects may be a lithium tantalate (Lt:LiTaO$_3$) substrate or a lithium niobate (Ln:LiNbO$_3$) substrate. Alternatively, the two bonded objects may be an acoustic wave device or an optical modulator. Here, ion implantation is performed in advance on at least one of the two bonded objects. Ions may be implanted into both of the two bonded objects. Usually, the ion implantation device is often provided separately from the above-described bonding system.

The bonder may include, for example, a chamber, a stage disposed in the chamber and supporting any one of two bonded objects, a head disposed in the chamber to oppose the stage and supporting the other of the two bonded objects, and a drive unit that moves at least one of the stage and the head in a first direction in which the stage and the head get close to each other or a second direction in which the head and the head get away from each other. Then, the control unit may control the first heat treatment device to heat the bonding surfaces to be bonded to each other of the two bonded objects in a reduced-pressure atmosphere to a temperature of 60°C or higher and lower than 150°C, then control the activation treatment device to activate the bonding surface of each of the two bonded objects in a state of maintaining the reduced-pressure atmosphere, then control the drive unit to move at least one of the stage and the head in the first direction in a state of maintaining the reduced-pressure atmosphere, thereby bonding the two bonded objects, and then control the second heat treatment device to heat the two bonded objects bonded to each other to a temperature of 210°C or higher and lower than 300°C. The first heat treatment device may be provided with a heater on at least one of the head and the stage, or may be used as the above-described second heat treatment device.

The bonding system according to the present modification may include a conveyance device that conveys two bonded objects bonded between any two of the first heat treatment device, the activation treatment device, the bonder, and the second heat treatment device after performing heat treatment on at least one of the two bonded objects by the first heat treatment device and before performing heat treatment on the two bonded objects by the second heat treatment device. In this case, when conveying the two bonded objects having been bonded, the conveyance device may maintain the two bonded objects to be conveyed at a temperature of 50°C or higher.

In an acoustic wave device such as a SAW filter prepared by bonding a lithium tantalate (Lt:LiTaO$_3$) substrate or a lithium niobate (Ln:LiNbO$_3$) substrate and a Si substrate, a SiO$_2$ substrate, a sapphire substrate, or the like to each other, it is necessary to reduce the thickness of the lithium tantalate (Lt:LiTaO$_3$) substrate or the lithium niobate (Ln:LiNbO$_3$) substrate to about several $\mu$m in order to improve frequency characteristics. On the other hand, due to a difference in linear expansion coefficient between a lithium tantalate (Lt:LiTaO$_3$) substrate or a lithium niobate (Ln:LiNbO$_3$) substrate and a Si substrate, a SiO$_2$ substrate, a sapphire substrate or the like, when these bonded objects are bonded at a temperature of 150°C or higher, warpage or cracking occurs at the stage of returning to normal temperature after bonding. Therefore, conventionally, it is common to perform activation treatment of a bonding surface of a bonded object by irradiating the bonded object with a particle beam in an ultrahigh vacuum environment, then bond the bonded objects at normal temperature, and thinly cut a lithium tantalate (Lt:LiTaO$_3$) substrate or a lithium niobate (Ln:LiNbO$_3$) substrate by polishing treatment after the bonding. However, in this case, the thickness of the lithium tantalate (Lt:LiTaO$_3$) substrate or the lithium niobate (Ln:LiNbO$_3$) substrate is limited to about 50 $\mu$m, and the frequency characteristics cannot be sufficiently improved. In particular, in order to improve frequency characteristics in a high frequency region, it is necessary to set the thickness of the lithium tantalate (Lt:LiTaO$_3$) substrate or the lithium niobate (Ln:LiNbO$_3$) substrate to at least 10 $\mu$m or less.

An optical modulator using a lithium niobate (Ln:LiNbO$_3$) substrate as an optical waveguide may be manufactured by bonding the lithium niobate (Ln:LiNbO$_3$) substrate to a Si substrate or the like. In this case, it is necessary to thin the lithium niobate (Ln:LiNbO$_3$) substrate according to the wavelength of light transmitted through the optical waveguide, and it is also necessary to set the thickness to 10 $\mu$m or less in order to improve the light modulation characteristics in the high frequency region. An optical modulator may have a lithium tantalate (Lt:LiTaO$_3$) substrate as an optical waveguide by bonding a lithium tantalate (Lt:LiTaO$_3$) substrate instead of the lithium niobate (Ln:LiNbO$_3$) substrate to a Si substrate or the like.

Conventionally, there is a smart cut technique as a technique adopted as a manufacturing technique of a silicon on insulator (SOI) substrate. This smart cut technique is a fine treatment technique in which hydrogen atoms are implanted into a Si single crystal substrate to a depth of several $\mu$m by an ion implantation method at a high concentration, and then the Si single crystal substrate is subjected to heat treatment at a temperature of 200°C or higher to cut a bond between Si in the Si single crystal, and the entire surface of the Si single crystal substrate is peeled off by a thickness of several $\mu$m. Application to preparation of SOI elements, single crystal Si thin films for next-generation solar cells, and the like is ongoing.

However, in a case of applying this smart cut technology to a lithium tantalate (Lt:LiTaO$_3$) substrate or a lithium niobate (Ln:LiNbO$_3$) substrate bonded to a Si substrate or the like, it is necessary to perform heat treatment at a temperature of 200°C or higher after bonding, and warpage or cracking occurs in the lithium tantalate (Lt:LiTaO$_3$) substrate or the lithium niobate (Ln:LiNbO$_3$) substrate. For this reason, the smart cut technology has not been able to be applied to such application.

On the other hand, the bonding method according to the present modification is a method developed in order to cope with these applications, and by using the above-described heat treatment method, ions are implanted into a material on a side to be thinned in advance, and after heat treatment is performed at a temperature of 60°C or higher and lower than 150°C, activation treatment is performed and then bonding is performed. Then, heat treatment is performed in which the temperature of the bonded object is heated to a temperature of 200°C or higher while being maintained at a temperature at which cracking or warpage does not occur without lowering the temperature of the bonded object to a temperature at which cracking or warpage occurs. Accordingly, a thin lithium tantalate (Lt:LiTaO$_3$) substrate or a lithium niobate (Ln:LiNbO$_3$) substrate can be easily manufactured because they can be peeled off at a depth of about several μm into which ions are implanted without causing cracking or warpage. Since a method of performing heat treatment before performing a bonding process is used, the bonding strength between a lithium tantalate (Lt:LiTaO$_3$) substrate or a lithium niobate (Ln:LiNbO$_3$) substrate and what is called a support substrate such as a Si substrate can be increased, which is a new method that has been impossible by conventional room-temperature bonding.

Here, if the temperature of the heat treatment is too high, cracking occurs due to a difference in linear expansion when the temperature returns to normal temperature. Therefore, the temperature in the heat treatment is preferably 60°C or higher and lower than 150°C. Similarly, the difference between the temperature at the time of bonding after heat treatment and the temperature at the time of performing additional heat treatment for smart cut is preferably 210°C or more and less than 300°C because warpage or cracking occurs unless the difference is less than 150°C. When the temperature of the heat treatment is 60°C, the smart cut can be performed by heating to 210°C, and when the temperature of the heat treatment is 150°C, the smart cut can be performed by heating to 300°C. As a result, a thin lithium tantalate (Lt:LiTaO$_3$) substrate or a lithium niobate (Ln:LiNbO$_3$) substrate of several μm is firmly bonded to the support substrate. The remaining lithium tantalate (Lt:LiTaO$_3$) substrate or lithium niobate (Ln:LiNbO$_3$) substrate peeled off by the smart cut may be separated in the additional heat treatment process, and the bonded substrate and the remaining substrate may be individually discharged. Alternatively, the substrate may be peeled off after being discharged from the second heat treatment device. Furthermore, the thinly peeled substrate having a thickness of several μm is extremely thinner than the support substrate even if there is a difference in linear expansion coefficient between what is called a support substrate and the thin peeled substrate, and therefore warpage or cracking is less likely to occur, and there is often no problem even if the temperature is set to normal temperature after heat treatment.

Although the same heat treatment device can perform the above-described heat treatment and additional heat treatment, it takes time to increase or decrease the temperature, and thus it is preferable to perform the two heat treatment in different heat treatment devices from the viewpoint of improving mass productivity. However, since the temperature of the bonded object decreases when the bonded object is conveyed, it is preferable to heat the bonded object during conveyance. Then, by maintaining the temperature, at 50°C or higher, after the above-described heat treatment until the additional heat treatment is performed, it is possible to suppress the occurrence of warpage or cracking during the additional heat treatment.

In each embodiment, an example in which the bonded object is the substrates W1 and W2 has been described, but the present invention is not limited to this, and for example, the bonded object may be a chip and a substrate.

In each embodiment, an example in which water is sprayed onto the bonding surfaces of the substrates W1 and W2 in the water cleaning process to clean the bonded surfaces has been described. However, the present invention is not limited to this, and water cleaning may be performed by what is called a wet treatment method in which the substrates W1 and W2 are immersed in water. Alternatively, water cleaning treatment may be performed after the bonding surfaces of the substrates W1 and W2 are treated with hydrofluoric acid, other acids, an organic solvent, or the like. That is, the method of the water cleaning treatment is not particularly limited as long as particles and other substances adhering to the bonding surfaces of the substrates W1 and W2 are removed by cleaning at least using water.

In each embodiment, the heat treatment process, the cooling process, the hydrophilization process, the cleaning process, the process of driving Si into the bonding surface, and the Si particle deposition process of depositing Si particles onto the bonding surface are performed on the substrates W1 and W2, but the method is not necessarily limited to the method of performing all of these series of processes on both the substrates W1 and W2. For example, all of the above-described series of processes may be performed only on one of the substrates W1 and W2.

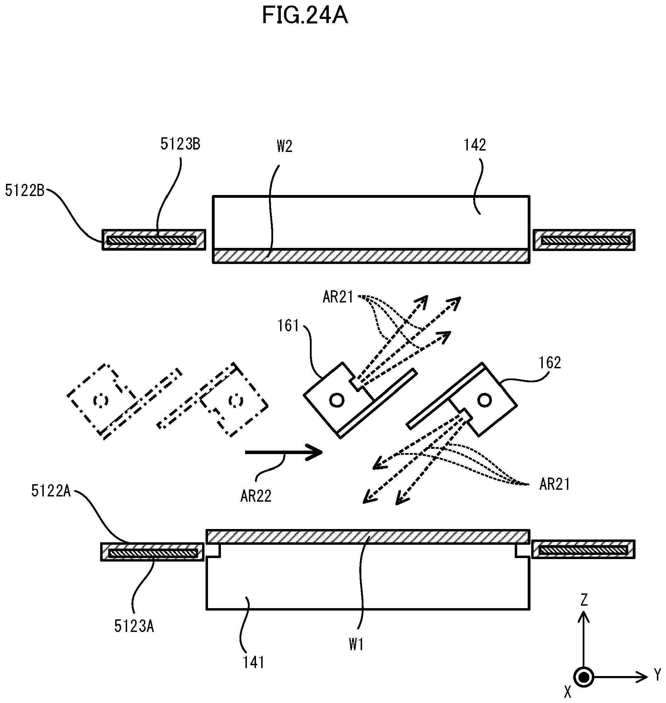

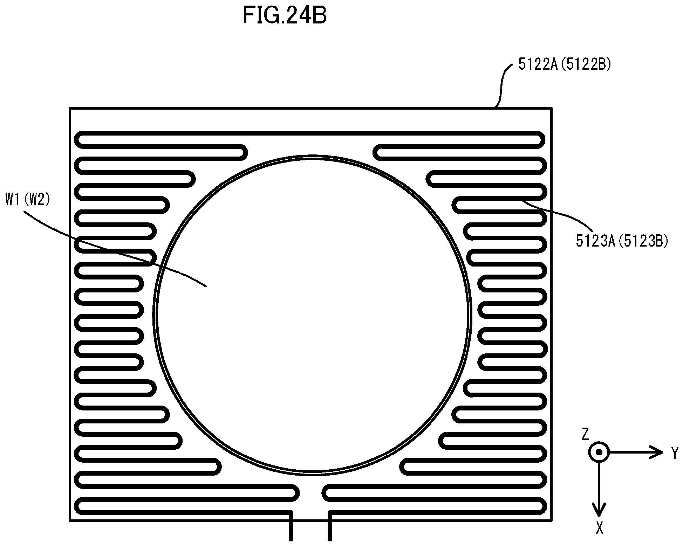

In each embodiment, an example in which the cover heating units 123A and 123B are heaters fixed to the covers 122A and 122B on the side opposite to the particle beam sources 161 and 162 has been described. However, the present invention is not limited to this, and for example, as illustrated in FIG. 24A, covers 5122A and 5122B may each be formed in a plate shape from glass and disposed to include an activation treatment region in an activation treatment process around the stage 141 and the head 142, and cover heating units 5123A and 5123B may be heaters including conductor patterns embedded in the covers 5122A and 5122B. Here, as illustrated in FIG. 24B, the cover heating units 5123A and 5123B include conductor patterns laid so as to cover the entire covers 5122A and 5122B.

In the present modification, when the chamber 120 is baked, a cover heating process of simultaneously heating the covers 5122A and 5122B is performed. At this time, since the cover heating units 5123A and 5123B are embedded in the covers 5122A and 5122B, the covers 5122A and 5122B are uniformly and efficiently heated, and the cover heating units 5123A and 5123B heat the entire covers 5122A and 5122B to a temperature higher than the temperature of the chamber 120.

As described in the embodiment, when the chamber 120 is baked in advance before the process of bonding the substrates W1 and W2 is performed, if the temperature of the covers 122A and 122B is lower than the temperature of the chamber 120, water or impurities adhering to the chamber 120 may be desorbed from the chamber 120 and adhere to the covers 122A and 122B. In this case, when the activation treatment is performed with the particle beam, impurities adhering to the covers 122A and 122B are sputtered by the particle beam and float in the chamber 120. Then, water or impurities floating in the chamber 120 may adhere to the bonding surfaces of the substrates W1 and W2, and the strength of bonding between the substrates W1 and W2 may be reduced. On the other hand, after the chamber 120 is baked, for example, in a state where a dummy substrate is held by the stage 141 and the head 142, a process of removing water or impurities adhering to the covers 122A and 122B is performed by performing what is called blanking of irradiating the dummy substrate and the covers 122A and 122B with the particle beam. However, since this what is called blanking process requires a time of about 1 hour to 4 hours, a treatment time loss occurs accordingly. The discharge chamber 1601 formed of the carbon material is excessively worn by the amount of the particle beams 161 and 162 used for blanking.

On the other hand, in the present modification, when the chamber 120 is baked, the cover heating units 5123A and 5123B perform the cover heating process of heating the entire covers 5122A and 5122B to a temperature higher than the temperature of the chamber 120. This makes it possible to suppress adhesion, to the covers 5122A and 5122B, of water or impurities desorbed from the chamber 120. Similarly to the effect of the heat treatment process described in the embodiment, it is possible to remove water or impurities adhering to the bonding surfaces of the substrates W1 and W2. Therefore, it is possible to secure the bonding strength between the substrates W1 and W2 even if the time for performing the above-described what is called blanking process is shortened or omitted.

In each embodiment, after the bonding process, a bonding strength evaluation process of evaluating the bonding strength of the substrates W1 and W2 using the above-described crack-and-opening method may be performed in an environment in vacuum (e.g., $1 \times 10^{-3}$ Pa or less). When moisture is contained in the environment for evaluating the bonding strength, the bonding strength that can be caused by progress of stress corrosion at the bonding interface due to the moisture becomes lower than the actual bonding strength. On the other hand, according to the present configuration, since the influence of moisture contained in the environment on the bonding strength can be suppressed, the bonding strength of the substrates W1 and W2 can be accurately evaluated.

The present invention enables various embodiments and modifications without departing from the broad spirit and scope of the present invention. The above-described embodiments are for describing the present invention, and do not limit the scope of the present invention. That is, the scope of the present invention is indicated not by the embodiments but by the claims. Various modifications made within the scope of the claims and the meaning of the invention equivalent thereto are regarded as being within the scope of the present invention.

The present application is based on Japanese Patent Application No. 2021-008275 filed on January 21, 2021, Japanese Patent Application No. 2021-162509 filed on October 1, 2021, and International Application No. PCT/JP2022/001970 filed on January 20, 2022. The entire description, claims, and drawings of Japanese Patent Application No. 2021-008275, the entire description, claims, and drawings of Japanese Patent Application No. 2021-162509, and the entire description, claims, and drawings of International Application No. PCT/JP2022/001970 are incorporated herein by reference.


Industrial Applicability

The present invention is suitable for manufacturing of, for example, a complementary MOS (CMOS) image sensor, a memory, an arithmetic element, and a micro electro mechanical system (MEMS).


Reference Signs List

    1 bonder
    3 cleaning device

9 control unit
82 first conveyance device
83 load lock unit
84 second conveyance device
120, 212 chamber
120a, 831a, 831b opening
121a, 201a, 832a vacuum pump
121b, 201b, 832b exhaust pipe
121c, 201c, 832c exhaust valve
122A, 122B, 5122A, 5122B cover
123A, 123B, 5123A, 5123B cover heating unit
141, 210 stage
142 head
143 stage drive unit
144 head drive unit
146 support mechanism
150 positional displacement amount measurement unit
161, 162 particle beam source
210a, 1411, 1421, 835, 8363 substrate heating unit
213 plasma chamber
215 induction coil
216 high-frequency power source
217 bias application unit
220A nitrogen gas supply unit
220B oxygen gas supply unit
221A nitrogen gas storage unit
221B oxygen gas storage unit
222A, 222B supply valve
223A, 223B supply pipe
811, 812 introduction port
813 takeout port
821 conveyance robot
821a arm
831 standby chamber
833a, 833b gate
834 gate drive unit
836 substrate holding mechanism
841 support rod
842 support
843 support drive unit
844 bellows
845 holding portion
1441, 8362 lift drive unit
1441a, 1445 pressure sensor
1442 XY direction drive unit
1443 rotation drive unit
1444 piezo actuator
1461, 1462 support member
1461a, 8361b protrusion
2002 activation treatment device
8361 cassette
8361a, 8451 support piece
8452 main portion
PLM plasma
TA target material
W1, W2 substrate

**Claims**

1.  A bonding method for bonding two bonded objects, the bonding method comprising:

    a heat treatment process of heating at least one of bonding surfaces to be bonded to each other of the two bonded objects to a temperature higher than 60°C in a reduced-pressure atmosphere;
    an activation treatment process of activating the bonding surface of each of the two bonded objects in a state of maintaining a reduced-pressure atmosphere after the heat treatment process; and
    a bonding process of bonding the two bonded objects in a state of maintaining a reduced-pressure atmosphere after the activation treatment process.

2.  The bonding method according to claim 1, wherein in the heat treatment process, a state where at least one of the bonding surfaces of the two bonded objects is heated to a temperature higher than 60°C for 30 seconds or more is maintained in a state of maintaining a reduced-pressure atmosphere.

3.  The bonding method according to claim 1 or 2, wherein an gas pressure in the heat treatment process is $10^{-2}$ Pa or less.

4.  The bonding method according to claim 3, wherein an gas pressure in the heat treatment process is $10^{-5}$ Pa or less.

5.  The bonding method according to any one of claims 1 to 4, wherein the heat treatment process is performed concurrently with at least one of the activation treatment process and the bonding process.

6.  The bonding method according to any one of claims 1 to 5, wherein in the activation treatment process, the bonding surface is irradiated with a particle beam.

7.  The bonding method according to claim 6, further comprising a Si particle deposition process of depositing Si on the bonding surface of at least one of the two bonded objects before the heat treatment process.

8.  The bonding method according to claim 7, wherein the activation treatment process is performed after the Si particle deposition process.

9.  The bonding method according to claim 6, wherein in the activation treatment process, at least one bonding surface of the two bonded objects is irradiated with Si particles together with the particle beam.

10. The bonding method according to any one of claims 1 to 9, wherein at least one of the two bonded objects has an oxide film or a nitride film on a bonding surface side.

11. The bonding method according to any one of claims 1 to 10, wherein

    at least one of the two bonded objects has an oxide film on the bonding surface side, and
    a Si layer having a thickness of 3 nm or more is formed on a surface of the oxide film.

12. The bonding method according to any one of claims 1 to 11, wherein at least one of the two bonded objects has an insulating film and a metal electrode exposed on the bonding surface.

13. The bonding method according to any one of claims 1 to 9, wherein at least one of the two bonded objects has a Si layer exposed on the bonding surface.

14. The bonding method according to any one of claims 1 to 13, further comprising a cooling process of cooling, to a temperature of 60°C or lower, the bonded object having been heated, the cooling process being performed after the heat treatment process and before the activation treatment process.

15. The bonding method according to any one of claims 1 to 14, further comprising a cleaning process of cleaning at least one bonding surface of the two bonded objects using at least water before the heat treatment process.

16. A bonding method for bonding two bonded objects, the bonding method comprising:

    a hydrophilization treatment process of hydrophilizing at least one bonding surface of the two bonded objects;

a heat treatment process of heating at least one of bonding surfaces to be bonded to each other of the two bonded objects to a temperature higher than 60°C in a reduced-pressure atmosphere after the hydrophilization treatment process; and

a bonding process of bonding the two bonded objects after the heat treatment process in a state of maintaining the reduced-pressure atmosphere.

17. The bonding method according to claim 16, wherein in the hydrophilization treatment process, at least one of the bonding surfaces of the two bonded objects is cleaned using at least water.

18. The bonding method according to claim 16 or 17, further comprising a Si particle deposition process of depositing Si on the bonding surface of at least one of the two bonded objects before the heat treatment process.

19. The bonding method according to claim 16 or 17, wherein Si particles are driven into at least one of the bonding surfaces of the two bonded objects.

20. The bonding method according to any one of claims 1 to 19, wherein in the bonding process, after the heat treatment process, after a temperature of the bonding surface having been heated of at least one of the two bonded objects is cooled to a temperature of 60°C or lower, the two bonded objects are bonded.

21. The bonding method according to any one of claims 1 to 15, wherein

the activation treatment process is performed in a chamber in which a cover is disposed to include an activation treatment region around at least one of the two bonded objects,

a cover heating process of heating the cover in a state where an inside of the chamber is brought into a reduced-pressure atmosphere performed before the activation treatment process is further included, and

the heat treatment process is performed simultaneously with the cover heating process.

22. A bonding method for bonding two bonded objects, the bonding method comprising:

a cover heating process of heating a cover in a state where an inside of a chamber in which the cover is disposed to include an activation treatment region around at least one of the two bonded objects is brought into a reduced-pressure atmosphere; and

a bonding process of bonding the two bonded objects after the cover heating process.

23. The bonding method according to claim 22, further comprising a chamber heating process of heating an inner wall of the chamber simultaneously with the cover heating process.

24. The bonding method according to claim 23, wherein a temperature of the cover in the cover heating process is higher than a temperature of the inner wall of the chamber in the chamber heating process.

25. The bonding method according to claim 24, further comprising an activation treatment process of activating a bonding surface of each of the two bonded objects after the cover heating process,

wherein the bonding process is performed after the activation treatment process.

26. The bonding method according to any one of claims 1 to 25, wherein before the bonding process, at least one bonding surface of the two bonded objects is irradiated with Si particles.

27. A bonding method for bonding two bonded objects, the bonding method comprising:

a heat treatment process of heating at least one of bonding surfaces to be bonded to each other of the two bonded objects to remove moisture remaining in the at least one of the bonding surfaces;

an activation treatment process of activating the bonding surface of each of the two bonded objects in a state of maintaining a reduced-pressure atmosphere after the heat treatment process; and

a bonding process of bonding the two bonded objects in a state where moisture remaining in the at least one is removed after the activation treatment process.

28. A bonding method for bonding two bonded objects, the bonding method comprising:

a bonding process of bonding the two bonded objects; and

a bonding strength evaluation process of evaluating bonding strength between the two bonded objects using a crack-and-opening method under an environment where a water amount is equal to or less than a preset reference water amount, the bonding strength evaluation process being performed after the bonding process.

29. A bonder that bonds two bonded objects, the bonder comprising:

a chamber;

a stage disposed in the chamber and supporting any one of the two bonded objects;

a head disposed to oppose the stage in the chamber and supporting another of the two bonded objects;

a first bonded object heating unit that heats at least one bonding surface of each of the two bonded objects to be bonded to each other to a temperature higher than 60°C in a state where the chamber or a standby chamber coupled to the chamber is in a reduced-pressure atmosphere;

an activation treatment unit that performs an activation treatment of activating the bonding surface of each of the two bonded objects;

a drive unit that moves at least one of the stage and the head to a first direction in which the stage and the head get close to each other or a second direction in which the stage and the head get away from each other; and

a control unit that controls operation of each of the first bonded object heating unit, the activation treatment unit, and the drive unit,

wherein the control unit bonds the two bonded objects by controlling the first bonded object heating unit to heat at least one of the bonding surfaces of each of the two bonded objects to a temperature higher than 60°C in a state where the two bonded objects are separated from each other in a state of maintaining a reduced-pressure atmosphere, then controlling the activation treatment unit to perform the activation treatment on the bonding surface in a state of maintaining a reduced-pressure atmosphere, and then controlling the drive unit to move at least one of the stage and the head to the first direction in a state of maintaining a reduced-pressure atmosphere.

30. The bonder according to claim 29, further comprising:

a standby chamber provided outside the chamber; and

a second bonded object heating unit that heats the bonding surface of at least one of the two bonded objects disposed in the standby chamber,

wherein the control unit controls the second bonded object heating unit to heat at least one of the bonding surfaces of each of the two bonded objects in a state where the two bonded objects are disposed in the standby chamber and the inside of the standby chamber is in a reduced-pressure atmosphere.

31. The bonder according to claim 29 or 30, wherein the activation treatment unit includes a particle beam source that irradiates the bonding surface with a particle beam.

32. The bonder according to any one of claims 29 to 31, further comprising a Si particle irradiation unit that deposits Si particles on the bonding surface of at least one of the two bonded objects.

33. The bonder according to claim 31, wherein the particle beam source irradiates a bonding surface of at least one of the two bonded objects with Si particles together with the particle beam.

34. The bonder according to any one of claims 29 to 33, wherein at least one of the two bonded objects has an oxide film or a nitride film exposed on the bonding surface.

35. The bonder according to any one of claims 29 to 33, wherein at least one of the two bonded objects has an insulating film and a metal electrode exposed on the bonding surface.

36. The bonder according to any one of claims 29 to 35, wherein the control unit controls the first bonded object heating unit to heat at least one of the bonding surface of each of the two bonded objects to a temperature higher than 60°C in a state where the two bonded objects are separated from each other in a state of maintaining a reduced-pressure atmosphere, and then cools the heated bonded object to a temperature of 60°C or lower before the activation treatment by the activation treatment unit.

37. The bonder according to any one of claims 29 to 36, further comprising:

a cover disposed around at least one of the stage and the head in the chamber; and

a cover heating unit that heats the cover,

wherein the control unit, before performing the activation treatment, controls the cover heating unit to heat the cover in a state where an inside of the chamber is brought into a reduced-pressure atmosphere.

38. The bonder according to claim 37, wherein

the cover is formed in a plate shape from glass and is disposed to include an activation treatment region activated in the activation treatment around at least one of the stage and the head, and

the cover heating unit heats the cover when a chamber heating process of heating an inner wall of the chamber is performed.

39. The bonder according to claim 38, wherein the cover heating unit heats the cover to a temperature higher than a temperature of the inner wall of the chamber heated in the chamber heating process.

40. A bonding system for bonding two bonded objects, the bonding system comprising:

a hydrophilization treatment device that hydrophilizes at least one of bonded surfaces of the two bonded objects using at least water;

a bonder including: a chamber; a first bonded object heating unit that heats at least one bonding surface of each of the two bonded objects to be bonded to each other to a temperature higher than 60°C in a state where the chamber or a standby chamber coupled to the chamber is in a reduced-pressure atmosphere; a stage disposed in the chamber and supporting any one of the two bonded objects; a head disposed to oppose the stage in the chamber and supporting another of the two bonded objects; and a drive unit that moves at least one of the stage and the head to a first direction in which the stage and the head get close to each other or a second direction in which the stage and the head get away from each other; and

a control unit that controls operation of each of the first bonded object heating unit and the drive unit,

wherein the control unit bonds the two bonded objects by controlling the first bonded object heating unit to heat at least one of the bonding surfaces of each of the two bonded objects to a temperature higher than 60°C in a reduced-pressure atmosphere, and then controlling the drive unit to move at least one of the stage and the head to the first direction in a state of maintaining a reduced-pressure atmosphere.

41. The bonding system according to claim 40, further comprising a cleaning device that cleans the bonding surface of at least one of the two bonded objects using at least water,

wherein the control unit controls the cleaning device to clean the bonding surface, and then controls the first bonded object heating unit to heat the bonding surface of each of the two bonded objects to a temperature higher than 60°C in a state where the two bonded objects are separated in a reduced-pressure atmosphere.

42. The bonding system according to claim 40 or 41, comprising:

a standby chamber provided outside the chamber; and

a holding mechanism disposed in the standby chamber and holding at least one of the two bonded objects, wherein the holding mechanism includes

a cassette having a plurality of slots disposed side by side in a vertical direction, and

a lift drive unit that raises and lowers the cassette, and

at least one of the two bonded objects before being bonded is held in a slot positioned on a most vertically lower side and a slot positioned on a most vertically upper side among the plurality of slots, and the two bonded objects bonded to each other are held in slots other than the slot positioned on the most vertically lower side and the slot positioned on the most vertically upper side among the plurality of slots.

43. A bonding method for bonding two bonded objects, the bonding method comprising:

an ion implantation process of implanting ions into at least one of the two bonded objects;

a heat treatment process of heating a bonding surface of each of the two bonded objects to be bonded to each other to a temperature of 60°C or higher and lower than 150°C in a reduced-pressure atmosphere after the ion implantation process;

an activation treatment process of activating the bonding surface of each of the two bonded objects in a state of maintaining a reduced-pressure atmosphere after the heat treatment process;

a bonding process of bonding the two bonded objects in a state of maintaining a reduced-pressure atmosphere after the activation treatment process; and

an additional heat treatment process of heating the two bonded objects having been bonded to a temperature of 210°C or higher and lower than 300°C after the bonding process.

44. The bonding method according to claim 43, wherein the heat treatment process and the additional heat treatment process are performed at different places, and the two bonded objects are maintained at a temperature of 50°C or higher when being conveyed from the place where the heat treatment process is performed to the place where the additional heat treatment process is performed.

45. The bonding method according to claim 43 or 44, wherein at least one of the two bonded objects is a lithium tantalate (Lt:LiTaO$_3$) or a lithium niobate substrate (Ln:LiNbO$_3$).

46. The bonding method according to any one of claims 43 to 45, wherein a bonded object obtained by peeling an ion-implanted substrate after the additional heat treatment process, with a thin film having a thickness of 10 μm or less being left is an acoustic wave device or an optical modulator.

47. A bonding system for bonding two bonded objects, the bonding system comprising:

a first heat treatment device that heats a bonding surface to be bonded to each other of the two bonded objects ion-implanted into at least one of the two bonded objects in a reduced-pressure atmosphere;

an activation treatment device that activates at least one bonding surface of the two bonded objects;

a bonder including a chamber, a stage disposed in the chamber and supporting any one of the two bonded objects, a head disposed in the chamber to oppose the stage and supporting another of the two bonded objects, and a drive unit that moves at least one of the stage and the head in a first direction in which the stage and the head get close to each other or a second direction in which the stage and the head get away from each other;

a second heat treatment device that heats the two bonded objects; and

a control unit that controls operation of each of the first heat treatment device, the activation treatment device, the drive unit, and the second heat treatment device,

wherein the control unit controls the first heat treatment device to heat a bonding surface to be bonded to each other of the two bonded objects ion-implanted into at least one of the two bonded objects in a reduced-pressure atmosphere to a temperature of 60°C or higher and lower than 150°C, then controls the activation treatment device to activate the bonding surface of each of the two bonded objects in a state of maintaining the reduced-pressure atmosphere, then controls the drive unit to move at least one of the stage and the head in the first direction in a state of maintaining the reduced-pressure atmosphere to bond the two bonded objects, and then controls the second heat treatment device to heat the two bonded objects bonded to each other to a temperature of 210°C or higher and lower than 300°C.

48. The bonding system according to claim 47, further comprising a conveyance device that conveys the two bonded objects bonded among any of the first heat treatment device, the activation treatment device, the bonder, and the second heat treatment device during a period from when at least one of the two bonded objects is subjected to heat treatment by the first heat treatment device to when the two bonded objects are subjected to heat treatment in the second heat treatment device,

wherein the conveyance device maintains at least one of the two bonded objects to be conveyed at a temperature of 50°C or higher when conveying the at least one of the two bonded objects bonded to each other.

49. The bonding system according to claim 47 or 48, wherein at least one of the two bonded objects is a lithium tantalate (Lt:LiTaO$_3$) or a lithium niobate substrate (Ln:LiNbO$_3$).

50. The bonding system according to any one of claims 47 to 49, wherein a bonded object obtained by peeling an ion-implanted substrate after performing the heat treatment by the second heat treatment device, with a thin film having a thickness of 10 μm or less being left is an acoustic wave device or an optical modulator.

FIG.1

EP 4 282 572 A1

## FIG.2

FIG.3

# FIG.4

# FIG.5

# FIG.6

## FIG.7A

# FIG.7B

# FIG.8

```
        ┌──────────────────────────────┐
        │       BONDING METHOD         │
        └──────────────────────────────┘
                       │
                       ▼
        ┌──────────────────────────────┐  S101
        │ CONVEY FROM INTRODUCTION PORT TO │
        │       CLEANING DEVICE        │
        └──────────────────────────────┘
                       │
                       ▼
        ┌──────────────────────────────┐  S102
        │       CLEANING PROCESS       │
        └──────────────────────────────┘
                       │
                       ▼
        ┌──────────────────────────────┐  S103
        │ CONVEY FROM CLEANING DEVICE TO LOAD │
        │        LOCK PORTION          │
        └──────────────────────────────┘
                       │
                       ▼
        ┌──────────────────────────────┐  S104
        │    HEAT TREATMENT PROCESS    │
        └──────────────────────────────┘
                       │
                       ▼
        ┌──────────────────────────────┐  S105
        │ CONVEY FROM LOAD LOCK PORTION TO │
        │        JOINING DEVICE        │
        └──────────────────────────────┘
                       │
                       ▼
        ┌──────────────────────────────┐  S106
        │    HEAT TREATMENT PROCESS    │
        └──────────────────────────────┘
                       │
                       ▼
        ┌──────────────────────────────┐  S107
        │  ACTIVATION TREATMENT PROCESS │
        └──────────────────────────────┘
                       │
                       ▼
        ┌──────────────────────────────┐  S108
        │       BONDING PROCESS        │
        └──────────────────────────────┘
                       │
                       ▼
        ┌──────────────────────────────┐  S109
        │ CONVEY FROM JOINING DEVICE TO LOAD │
        │          LOCK UNIT           │
        └──────────────────────────────┘
                       │
                       ▼
        ┌──────────────────────────────┐  S110
        │ CONVEY FROM LOAD LOCK UNIT TO │
        │         TAKEOUT PORT         │
        └──────────────────────────────┘
                       │
                       ▼
        ┌──────────────────────────────┐
        │            END               │
        └──────────────────────────────┘
```

FIG.9A

EP 4 282 572 A1

FIG.9B

EP 4 282 572 A1

FIG.10A

# FIG.10B

# FIG.11A

EP 4 282 572 A1

FIG.11B

EP 4 282 572 A1

FIG.12A

EP 4 282 572 A1

# FIG.12B

EP 4 282 572 A1

FIG.13A

FIG.13B

EP 4 282 572 A1

FIG.14A

# FIG.14B

FIG.15

# FIG.16

```
        ┌─────────────────────────────────────────┐
        │   HYDROPHILIZATION BONDING METHOD        │
        └─────────────────────────────────────────┘
                          │
                          ▼
        ┌─────────────────────────────────────────┐  S201
        │ CONVEY FROM INTRODUCTION PORT TO LOAD    │
        │              LOCK UNIT                   │
        └─────────────────────────────────────────┘
                          │
                          ▼
        ┌─────────────────────────────────────────┐  S202
        │  CONVEY FROM LOAD LOCK UNIT TO BONDER    │
        └─────────────────────────────────────────┘
                          │
                          ▼
        ┌─────────────────────────────────────────┐  S203
        │       ACTIVATION TREATMENT PROCESS       │
        └─────────────────────────────────────────┘
                          │
                          ▼
        ┌─────────────────────────────────────────┐  S204
        │  CONVEY FROM BONDER TO LOAD LOCK UNIT    │
        └─────────────────────────────────────────┘
                          │
                          ▼
        ┌─────────────────────────────────────────┐  S205
        │ CONVEY FROM LOAD LOCK UNIT TO CLEANING   │
        │              DEVICE                      │
        └─────────────────────────────────────────┘
                          │
                          ▼
        ┌─────────────────────────────────────────┐  S206
        │        WATER CLEANING PROCESS            │
        └─────────────────────────────────────────┘
                          │
                          ▼
        ┌─────────────────────────────────────────┐  S207
        │  CONVEY FROM CLEANING DEVICE TO LOAD     │
        │              LOCK UNIT                   │
        └─────────────────────────────────────────┘
                          │
                          ▼
        ┌─────────────────────────────────────────┐  S208
        │         HEAT TREATMENT PROCESS           │
        └─────────────────────────────────────────┘
                          │
                          ▼
        ┌─────────────────────────────────────────┐  S209
        │  CONVEY FROM LOAD LOCK UNIT TO BONDER    │
        └─────────────────────────────────────────┘
                          │
                          ▼
        ┌─────────────────────────────────────────┐  S210
        │         HEAT TREATMENT PROCESS           │
        └─────────────────────────────────────────┘
                          │
                          ▼
        ┌─────────────────────────────────────────┐  S211
        │             BONDING PROCESS              │
        └─────────────────────────────────────────┘
                          │
                          ▼
        ┌─────────────────────────────────────────┐  S212
        │  CONVEY FROM BONDER TO LOAD LOCK UNIT    │
        └─────────────────────────────────────────┘
                          │
                          ▼
        ┌─────────────────────────────────────────┐  S213
        │ CONVEY FROM LOAD LOCK UNIT TO TAKEOUT    │
        │              PORT                        │
        └─────────────────────────────────────────┘
                          │
                          ▼
        ┌─────────────────────────────────────────┐
        │                  END                     │
        └─────────────────────────────────────────┘
```

FIG.17A

FIG.17B

FIG.18

EP 4 282 572 A1

## FIG.19

# FIG.20

```
┌─────────────────────────────────────┐
│  HYDROPHILIZATION BONDING METHOD     │
└─────────────────────────────────────┘
                  │
                  ▼
┌─────────────────────────────────────┐  S301
│  CONVEY FROM INTRODUCTION PORT TO    │
│  ACTIVATION TREATMENT DEVICE         │
└─────────────────────────────────────┘
                  │
                  ▼
┌─────────────────────────────────────┐  S302
│  ACTIVATION TREATMENT PROCESS        │
└─────────────────────────────────────┘
                  │
                  ▼
┌─────────────────────────────────────┐  S303
│  CONVEY FROM ACTIVATION TREATMENT    │
│  DEVICE TO CLEANING DEVICE           │
└─────────────────────────────────────┘
                  │
                  ▼
┌─────────────────────────────────────┐  S304
│  WATER CLEANING PROCESS              │
└─────────────────────────────────────┘
                  │
                  ▼
┌─────────────────────────────────────┐  S305
│  CONVEY FROM CLEANING DEVICE TO LOAD │
│  LOCK UNIT                           │
└─────────────────────────────────────┘
                  │
                  ▼
┌─────────────────────────────────────┐  S306
│  HEAT TREATMENT PROCESS              │
└─────────────────────────────────────┘
                  │
                  ▼
┌─────────────────────────────────────┐  S307
│  CONVEY FROM LOAD LOCK UNIT TO       │
│  BONDER                              │
└─────────────────────────────────────┘
                  │
                  ▼
┌─────────────────────────────────────┐  S308
│  HEAT TREATMENT PROCESS              │
└─────────────────────────────────────┘
                  │
                  ▼
┌─────────────────────────────────────┐  S309
│  BONDING PROCESS                     │
└─────────────────────────────────────┘
                  │
                  ▼
┌─────────────────────────────────────┐  S310
│  CONVEY FROM JOINING DEVICE TO LOAD  │
│  LOCK UNIT                           │
└─────────────────────────────────────┘
                  │
                  ▼
┌─────────────────────────────────────┐  S311
│  CONVEY FROM LOAD LOCK UNIT TO       │
│  TAKEOUT PORT                        │
└─────────────────────────────────────┘
                  │
                  ▼
┌─────────────────────────────────────┐
│              END                     │
└─────────────────────────────────────┘
```

# FIG.21

# FIG.22

# FIG.23

# FIG.24A

FIG.24B

## INTERNATIONAL SEARCH REPORT

| International application No. |
| --- |
| **PCT/JP2022/002175** |

**A. CLASSIFICATION OF SUBJECT MATTER**

***B23K 20/00***(2006.01)i; ***H01L 21/02***(2006.01)i
FI:   H01L21/02 B; B23K20/00 310L; B23K20/00 310P; B23K20/00 310A

According to International Patent Classification (IPC) or to both national classification and IPC

**B. FIELDS SEARCHED**

Minimum documentation searched (classification system followed by classification symbols)

H01L21/02; B23K20/00-20/26

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2014-103291 A (RENESAS ELECTRONICS CORP) 05 June 2014 (2014-06-05) paragraphs [0014]-[0093], fig. 1-8 | 1-5, 10-11, 13-17, 20, 27, 43-46 |
| Y | | 6-15, 18-20, 26, 29-36, 40-41, 43-50 |
| A | | 21-25, 37-39, 42 |
| X | JP 2018-74050 A (BONDTECH INC) 10 May 2018 (2018-05-10) paragraphs [0014]-[0070], fig. 1-11 | 28 |
| Y | | 6-15, 19-20, 26, 29-36, 40-41, 45-50 |
| A | | 21-25, 37-39, 42 |
| Y | WO 2015/163461 A1 (SUGA, Tadatomo) 29 October 2015 (2015-10-29) paragraphs [0031]-[0058], [0096]-[0177], [0198], fig. 1, 4-10 | 6-15, 19-20, 26, 29-36, 40-41, 45-50 |
| A | | 21-25, 37-39, 42 |

☑ Further documents are listed in the continuation of Box C.       ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **05 April 2022** | **19 April 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

## INTERNATIONAL SEARCH REPORT

International application No.

**PCT/JP2022/002175**

**C.** **DOCUMENTS CONSIDERED TO BE RELEVANT**

| Category* | Citation of document, with indication, where appropriate, of the relevant passages | Relevant to claim No. |
|---|---|---|
| Y | WO 2017/155002 A1 (BONDTECH INC) 14 September 2017 (2017-09-14) paragraphs [0023]-[0048], [0101]-[0139], fig. 1 | 6-15, 19-20, 26, 29-36, 40-41, 47 |
| A | | 21-25, 37-39, 42 |
| Y | JP 2004-297693 A (FUJITSU MEDIA DEVICE KK) 21 October 2004 (2004-10-21) paragraphs [0029]-[0037], fig. 2-4 | 6-15, 19-20, 26, 31-36, 45-46, 49-50 |
| A | | 21-25, 37-39, 42 |
| X | WO 2012/105474 A1 (SUGA, Tadatomo) 09 August 2012 (2012-08-09) paragraphs [0023]-[0061], fig. 2-6 | 28 |
| Y | | 7-8, 10-15, 18, 20, 26, 32, 34-36 |
| A | | 21-25, 37-39, 42 |
| Y | JP 2010-109949 A (MURATA MFG CO LTD) 13 May 2010 (2010-05-13) paragraphs [0039]-[0047], [0061], fig. 1-5 | 43-50 |
| A | | 21-25, 37-39, 42 |
| A | JP 2008-71787 A (USHIO ELECTRIC INC) 27 March 2008 (2008-03-27) | 21-25, 37-39, 42 |

Form PCT/ISA/210 (second sheet) (January 2015)

**INTERNATIONAL SEARCH REPORT**
Information on patent family members

International application No.

**PCT/JP2022/002175**

| Patent document cited in search report | | | Publication date (day/month/year) | Patent family member(s) | | | Publication date (day/month/year) |
|---|---|---|---|---|---|---|---|
| JP | 2014-103291 | A | 05 June 2014 | US paragraphs [0025]-[0104], fig. 1-8 | 2014/0141560 | A1 | |
| JP | 2018-74050 | A | 10 May 2018 | (Family: none) | | | |
| WO | 2015/163461 | A1 | 29 October 2015 | JP | 2018-201022 | A | |
| | | | | US paragraphs [0049]-[0076], [0114]-[0192], [0213], fig. 1, 4-10 | 2017/0047225 | A1 | |
| | | | | EP | 3136422 | A1 | |
| WO | 2017/155002 | A1 | 14 September 2017 | TW | 201802867 | A | |
| JP | 2004-297693 | A | 21 October 2004 | US paragraphs [0032]-[0040], fig. 2-4 | 2004/0189146 | A1 | |
| | | | | KR | 10-0607607 | B1 | |
| | | | | CN | 1534868 | A | |
| WO | 2012/105474 | A1 | 09 August 2012 | US paragraphs [0078]-[0116], fig. 2-6 | 2014/0037945 | A1 | |
| | | | | EP | 2672507 | A1 | |
| | | | | CN | 103460339 | A | |
| | | | | KR | 10-2014-0053842 | A | |
| JP | 2010-109949 | A | 13 May 2010 | US paragraphs [0047]-[0055], [0070], fig. 1-5 | 2010/0107388 | A1 | |
| | | | | EP | 2182561 | A2 | |
| JP | 2008-71787 | A | 27 March 2008 | US | 2008/0219650 | A1 | |
| | | | | EP | 1901335 | A1 | |
| | | | | KR | 10-2008-0024060 | A | |
| | | | | TW | 200818265 | A | |

Form PCT/ISA/210 (patent family annex) (January 2015)

**REFERENCES CITED IN THE DESCRIPTION**

**Patent documents cited in the description**

- JP 2014113633 A
- JP 2021008275 A
- JP 2021162509 A
- JP 2022001970 W